# EUROPEAN PATENT APPLICATION

(11) **EP 2 293 343 A1**
(43) Date of publication of application: **09.03.2011**
(21) Application number: 09758422.1
(22) Date of filing: 05.06.2009
(51) Int. Cl.: H01L 31/04, C23C 16/505, H01L 21/205

(54) **APPARATUS FOR MANUFACTURING THIN FILM SOLAR CELL**

(30) Priority: 06.06.2008 JP 2008149937
(71) Applicant: Ulvac, Inc., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); JIMBO Yosuke, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP); HASHIMOTO Masanori, Sammu-shi Chiba 289-1226 (JP); WAKAMATSU Sadatsugu, Sammu-shi Chiba 289-1226 (JP)
(74) Representative: Eisenführ, Speiser & Partner
(86) International application number: PCT/JP2009/060356
(87) International publication number: WO 2009/148155

(57) **Abstract**

A thin-film solar cell manufacturing apparatus, includes: a film formation space (81) in which a substrate (W) is disposed so that a film formation face of the substrate (W) is substantially parallel to a direction of gravitational force, and in which a desired film is formed on the film formation face by a CVD method; a cathode unit (68, 118, 128) including cathodes (75) to which a voltage is applied, and two or more power feeding points (88), the cathodes (75) being disposed at both sides of the cathode unit (68, 118, 128); and an anode (67) distantly disposed so as to face the cathodes (75) that are disposed at both sides of the cathode unit (68, 118, 128).

## Description

### BACKGROUND OF THE INVENTION

### Field of the Invention

The present invention relates to a thin-film solar cell manufacturing apparatus.

This application claims priority from Japanese Patent Application No. 008-149937 filed on June 6, 2008, the contents of which are incorporated herein by reference in their entirety.

### Background Art

Since most materials currently used for solar cells are accounted for by single crystal Si type and polycrystal Si type materials, there are growing concerns about material shortages or the like of Si.

Thus, the demand has recently been increasing for thin-film solar cells formed with a thin-film Si-layer in which the manufacturing cost is low and the risk of material shortages is low.

Moreover, in addition to conventional thin-film solar cells having only an a-Si (amorphous silicon) layer, the demand for tandem-type thin-film solar cells has recently been increasing. In the tandem-type thin-film solar cell, the conversion efficiency thereof is improved by stacking an a-Si-layer and a µc-Si (microcrystalline silicon) layer in layers.

A plasma-CVD apparatus is often used as an apparatus which performs film forming of a thin-film Si-layer (semiconductor layer) constituting the thin-film solar cells.

The plasma-CVD apparatus has a film forming chamber, and is configured such that a substrate on which a film is formed is stored within this film forming chamber, and a film forming gas is supplied into the film forming chamber after the internal pressure of the film forming chamber has been reduced to a vacuum.

Additionally, a high-frequency electrode (cathode) which generates the plasma of the film forming gas is installed within the film forming chamber.

A desired film is formed on the film formation face of a heated substrate when the film forming gas (radical) decomposed by the plasma reaches the film formation face (face on which a film is formed) of the substrate.

The high-frequency electrode is connected to a high-frequency power source via a matching circuit.

The high-frequency power source has an oscillating circuit or an amplifying circuit, and receives the input of an alternating current or a direct current and outputs high-frequency power.

The matching circuit is a circuit which accomplishes the matching between the high-frequency power source and the high-frequency electrode, and the desired high-frequency power is input to the high-frequency electrode by this matching circuit (for example, refer to Japanese Unexamined Patent Application, First Publication No. 2005-158980).

Meanwhile, in the high-frequency electrode of the above-described CVD apparatus, one power feeding point for inputting high-frequency power is often provided substantially at the center of the plane of the high-frequency electrode.

By arranging the power feeding point at the center of the high-frequency electrode, it becomes easy to supply electric power of the same electrical potential to the whole high-frequency electrode, and thereby, a uniform film can be formed on the whole film formation face of a substrate.

However, if the high-frequency electrode is enlarged, an electrical potential difference is caused between a central portion and a lateral portion (peripheral portion) of the high-frequency electrode only by providing one power feeding point substantially at the center of the plane in this high-frequency electrode. Thus, there is problem in that it is hard to form a uniform film on the whole film formation face of the substrate.

Additionally, even if the whole high-frequency electrode can be uniformly made to have the same electrical potential, there is a problem in that it is difficult to uniformly form a film on the whole film formation face of the substrate according to the conditions when film forming is performed, such as when the temperature of a substrate does not become generally uniform.

### SUMMARY OF THE INVENTION

Thus, the present invention has been made in consideration of the above circumstances, and the object thereof is to provide a thin-film solar cell manufacturing apparatus capable of forming a uniform film on a film formation face of a substrate, even if a high-frequency electrode is enlarged or the conditions when a film is formed have changed.

In order to realize high productivity while obtaining high film quality, the inventors in this case have studied a thin-film solar cell manufacturing apparatus in which a cathode unit having electric discharge faces (cathodes) on both sides thereof are provided at the center and anodes are arranged in a separated out manner on both surfaces of the cathode unit.

In such a parallel plate type plasma-CVD apparatus, discharge spaces are formed on both sides of the cathode unit.

When the balance between the impedances of these two discharge spaces has collapsed, there is a possibility that electric discharge may be biased to one side, and plasma may be nonuniformly generated.

In order to avoid this, there is a problem in that severe adjustment of an electrode gap or the like is required.

A thin-film solar cell manufacturing apparatus of a first aspect of the present invention, includes: a film formation space in which a substrate is disposed so that a film formation face of the substrate is substantially parallel to a direction of gravitational force, and in which a desired film is formed on the film formation face by a CVD method; a cathode unit including cathodes to which a voltage is applied, and two or more power feeding points, the cathodes being disposed at both sides of the cathode unit; and an anode distantly disposed so as to face the cathodes that are disposed at both sides of the cathode unit.

In the thin-film solar cell manufacturing apparatus of the first aspect of the present invention, even if the cathode is enlarged, the cathode with a plurality of power feeding points is provided, so that the electrical potential of the whole cathode can be uniformly set.

Additionally, it is possible to adjust the electrical potentials applied to the respective power feeding points while checking the quality of a film formed on a substrate.

For this reason, for example, even if the temperature of a substrate does not become generally uniform, a uniform film can be formed on a film formation face of the substrate.

Moreover, since the anodes are respectively arranged on both sides of the cathode so as to face the cathode, it is possible to simultaneously form films on two substrates in a space where space-saving has been realized.

A thin-film solar cell manufacturing apparatus of a second aspect of the present invention, includes: a film formation space in which a substrate is disposed so that a film formation face of the substrate is substantially parallel to a direction of gravitational force, and in which a desired film is formed on the film formation face by a CVD method; a cathode unit including cathodes to which a voltage is applied and an insulating member disposed between a pair of the cathodes, the cathodes having two or more power feeding points to which the same electrical potentials are applied, the cathodes being disposed at both sides of the cathode unit; and an anode distantly disposed so as to face the cathodes that are disposed at both sides of the cathode unit.

In the thin-film solar cell manufacturing apparatus of the second aspect of the present invention, the floating capacitance is provided by inserting a dielectric body (insulating member) between two cathodes. Thus, mutual interference between the two electrodes (cathodes) can be suppressed by this floating capacitance.

A thin-film solar cell manufacturing apparatus of a third aspect of the present invention, includes: a film formation space in which a substrate is disposed so that a film formation face of the substrate is substantially parallel to a direction of gravitational force, and in which a desired film is formed on the film formation face by a CVD method; a cathode unit including cathodes to which a voltage is applied and a shield member disposed between a pair of the cathodes, the cathodes having two or more power feeding points to which electrical potentials different from each other are applied, the shield member having a ground potential, the cathodes being disposed at both sides of the cathode unit; and an anode distantly disposed so as to face the cathodes that are disposed at both sides of the cathode unit.

In the thin-film solar cell manufacturing apparatus of the third aspect of the present invention, it is possible to apply voltages to a pair of cathodes, without mutual interference between the voltages to be applied to the pair of cathodes.

For this reason, electric discharges of two film formation spaces are performed without mutual interference therebetween, and a film can be uniformly and stably formed.

A thin-film solar cell manufacturing apparatus of a fourth aspect of the present invention, includes: a film formation space in which a substrate is disposed so that a film formation face of the substrate is substantially parallel to a direction of gravitational force, and in which a desired film is formed on the film formation face by a CVD method; a cathode unit including cathodes to which a voltage is applied and a cathode intermediate member having two or more power feeding points disposed at a side face of the cathode intermediate member, the cathodes being disposed at both sides of the cathode intermediate member, and the cathodes being disposed at both sides of the cathode unit; and an anode distantly facing the cathodes that are disposed at both sides of the cathode unit.

In the thin-film solar cell manufacturing apparatus of the fourth aspect of the present invention, the cathode intermediate member which has cathodes installed on both sides thereof has a power feeding point, and has two or more power feeding points. Thus, it is unnecessary to provide a power feeding point for every cathode, and it is possible to apply voltages of the same electrical potential and phase.

According to the present invention, even if the cathode is enlarged, the cathode with a plurality of power feeding points is provided, so that the electrical potential of the whole cathode can be uniformly set.

Additionally, in the present invention, it is possible to adjust the electrical potentials applied to the respective power feeding points while checking the quality of a film formed on a substrate.

For this reason, for example, even if the impedance of each electrode is different, it is possible to generate stable electric discharge, and a uniform film can be formed on the film formation face of a substrate.

### BRIEF DESCRIPTION OF THE DRAWINGS

FIG. 1 is a schematic sectional view showing a thin-film solar cell in a first embodiment of the present invention.
FIG. 2 is a schematic configuration view showing a thin-film solar cell manufacturing apparatus in the first embodiment of the present invention.
FIG. 3A is a perspective view showing a film forming chamber in the first embodiment of the present invention.
FIG. 3B is the perspective view when the film forming chamber in the first embodiment of the present invention is seen from a different angle.
FIG. 3C is a side view showing the film forming chamber in the first embodiment of the present invention.
FIG. 4A is a perspective view showing an electrode unit in the first embodiment of the present invention.
FIG. 4B is the perspective view when the electrode unit in the first embodiment of the present invention is seen from a different angle.
FIG. 4C is an exploded perspective view showing the electrode unit in the first embodiment of the present invention.
FIG. 4D is a sectional view showing a part of a cathode unit and anode unit of the electrode unit in the first embodiment of the present invention.
FIG. 5 is a plan view showing a cathode in the first embodiment of the present invention.
FIG. 6A is a perspective view showing a loading-ejecting chamber in the first embodiment of the present invention.
FIG. 6B is a perspective view showing the loading-ejecting chamber in the first embodiment of the present invention is seen from a different angle.
FIG. 7 is a schematic configuration view showing a push-pull mechanism in the first embodiment of the present invention.
FIG. 8A is a perspective view showing a schematic configuration of a substrate replacement chamber in the first embodiment of the present invention.
FIG. 8B is a front view showing a schematic configuration of the substrate replacement chamber in the first embodiment of the present invention.
FIG. 9 is a perspective view showing a substrate storage holder in the first embodiment of the present invention.
FIG. 10 is a perspective view showing a carrier in the first embodiment of the present invention.
FIG. 11 is an explanatory view (1) showing a process of a method for manufacturing a thin-film cell in the first embodiment of the present invention.
FIG. 12 is an explanatory view (2) showing a process of the method for manufacturing a thin-film cell in the first embodiment of the present invention.
FIG. 13 is an explanatory view (3) showing a process of the method for manufacturing a thin-film cell in the first embodiment of the present invention.
FIG. 14 is an explanatory view (4) showing a process of the method for manufacturing a thin-film cell in the first embodiment of the present invention.
FIG. 15 is an explanatory view (5) showing a process of the method for manufacturing a thin-film cell in the first embodiment of the present invention.
FIG. 16A is an explanatory view showing the operation of the push-pull mechanism in the first embodiment of the present invention.
FIG. 16B is an explanatory view showing the operation of the push-pull mechanism in the first embodiment of the present invention.
FIG. 17 is an explanatory view (6) showing a process of the method for manufacturing a thin-film cell in the first embodiment of the present invention.
FIG. 18 is an explanatory view (7) showing a process of the method for manufacturing a thin-film cell in the first embodiment of the present invention.
FIG. 19 is an explanatory view (8) showing a process of the method for manufacturing a thin-film cell in the first embodiment of the present invention, and is a sectional view showing a schematic configuration when substrates are inserted into the electrode unit.
FIG. 20 is an explanatory view (9) showing a process of the method for manufacturing a thin-film cell in the first embodiment of the present invention.
FIG. 21 is an explanatory view (10) showing a process of the method for manufacturing a thin-film cell in the first embodiment of the present invention.
FIG. 22 is an explanatory view (11) showing a process of the method for manufacturing a thin-film cell in the first embodiment of the present invention, and a sectional view showing a configuration in which substrates are partially set on the electrode unit.
FIG. 23 is an explanatory view (12) showing a process of the method for manufacturing a thin-film cell in the first embodiment of the present invention.
FIG. 24 is an explanatory view (13) showing a process of the method for manufacturing a thin-film cell in the first embodiment of the present invention.
FIG. 25 is an explanatory view (14) showing a process of the method for manufacturing a thin-film cell in the first embodiment of the present invention.
FIG. 26 is an explanatory view (15) showing a process of the method for manufacturing a thin-film cell in the first embodiment of the present invention.
FIG. 27 is a sectional view showing parts of the cathode unit and anodes in a second embodiment of the present invention.
FIG. 28 is a sectional view showing parts of the cathode unit and anodes in a third embodiment of the present invention.

### DESCRIPTION OF THE PREFERRED EMBODIMENTS

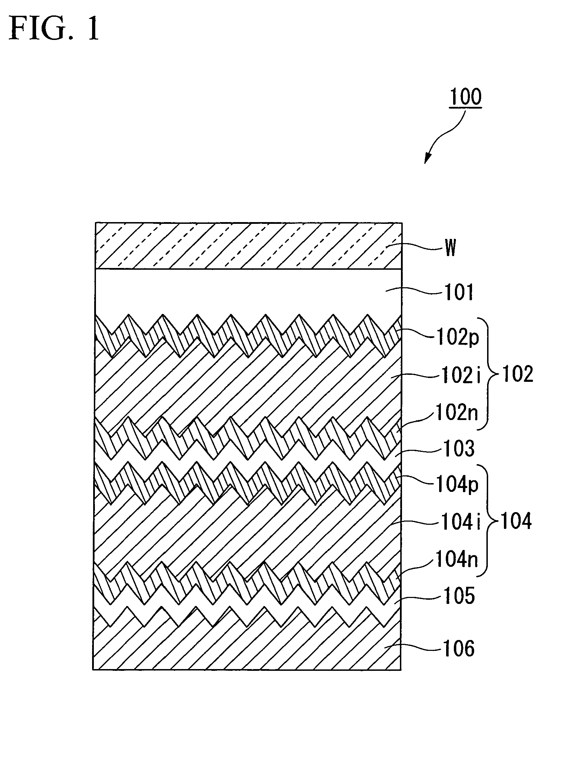

A thin-film solar cell manufacturing apparatus related to an embodiment of the present invention will be described with reference to FIGS. 1 to 28.

### (Thin-film Solar Cell)

FIG. 1 is a schematic sectional view of a thin-film solar cell 100 manufactured by a thin-film solar cell manufacturing apparatus of the present invention.

As shown in FIG. 1, the thin-film solar cell 100 is configured such that a substrate W which constitutes the surface of the solar cell and is made of glass; a top electrode 101 made of a transparent-electroconductive film provided on the substrate W; a top cell 102 made of amorphous silicon; an intermediate electrode 103 made of a transparent-electroconductive film provided between the top cell 102 and a bottom cell 104 which will be described later; the bottom cell 104 made of microcrystalline silicon; a buffer layer 105 made of a transparent-electroconductive film; and a back electrode 106 made of a metal film are stacked in layers.

That is, the thin-film solar cell 100 is an a-Si/microcrystal Si tandem-type solar cell.

In the thin-film solar cell 100 having such a tandem structure, power generation efficiency can be improved by absorbing short-wavelength light by the top cell 102 and absorbing long-wavelength light by the bottom cell 104.

A three-layer structure of a p-layer (1 02p), i-layer (102i), and n-layer (102n) of the top cell 102 is formed from amorphous silicon.

Additionally, a three-layer structure of a p-layer (104p), i-layer (104i), and n-layer (104n) of the bottom cell 104 is made of microcrystalline silicon.

In the thin-film solar cell 100 having such a configuration, when an energy particle called a photon in sunlight strikes the i-layer, an electron and a positive hole are generated by a photovoltaic effect, the electron moves toward the n-layer and the positive hole moves toward the p-layer.

Light energy can be converted into electrical energy by taking out the electron/positive hole generated by the photovoltaic effect of the top electrode 101 and the back electrode 106.

Additionally, the intermediate electrode 103 is provided between the top cell 102 and the bottom cell 104, whereby a part of the light which passes through the top cell 102 and reaches the bottom cell 104 is reflected by the intermediate electrode 103 and enters the top cell 102 again. Therefore, the sensitivity of the cell improves, and the power generation efficiency improves.

Additionally, the sunlight which has entered the substrate W side passes through the respective layers, and is then reflected by the back electrode 106.

In the thin-film solar cell 100, a texture structure is adopted, which is formed in order to improve the conversion efficiency of light energy, in order to obtain a prismatic effect which extends the optical path of the sunlight which has entered the top electrode 101, and in order to obtain the confinement effect of light.

### (First Embodiment)

Next, the thin-film solar cell manufacturing apparatus of the present invention will be described.

### (Thin-film Solar Cell Manufacturing Apparatus)

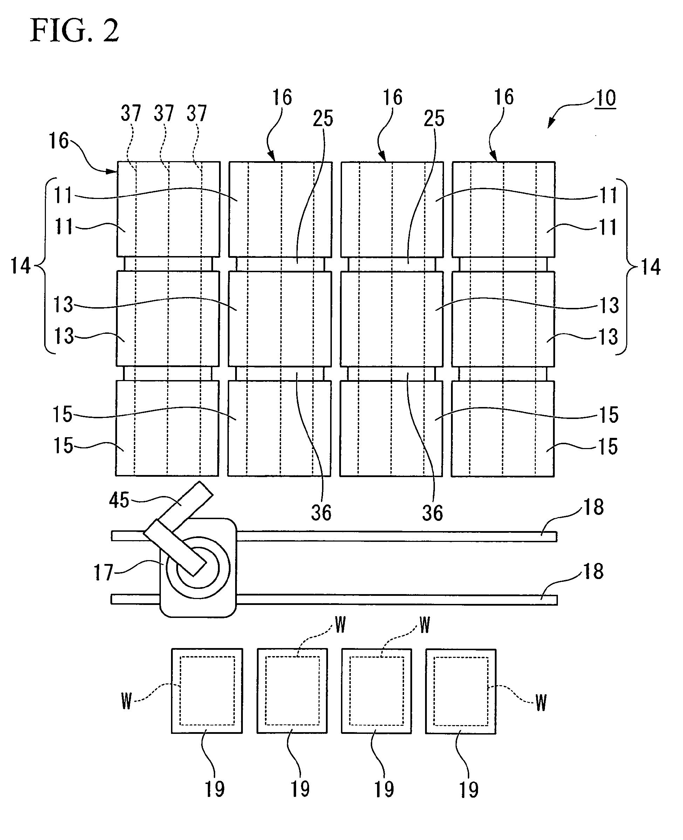

FIG. 2 is a schematic configuration view of a thin-film solar cell manufacturing apparatus.

As shown in FIG. 2, the thin-film solar cell manufacturing apparatus 10 includes film forming chambers 11, loading-ejecting chambers 13, substrate replacement chambers 15, a substrate replacement robot 17, and substrate storage holders 19.

The film forming chambers 11 simultaneously film-form bottom cells 104 (semiconductor layers) made of microcrystalline silicon on a plurality of substrates W.

The loading-ejecting chambers 13 simultaneously store both pre-processed substrates W1 which are to be transported to the film forming chambers 11 and post-processed substrates W2 which have been transported from the film forming chambers 11.

In the following description, the "pre-processed substrate" means a substrate before film formation processing, and the "post-processed substrate" means a substrate after film formation processing.

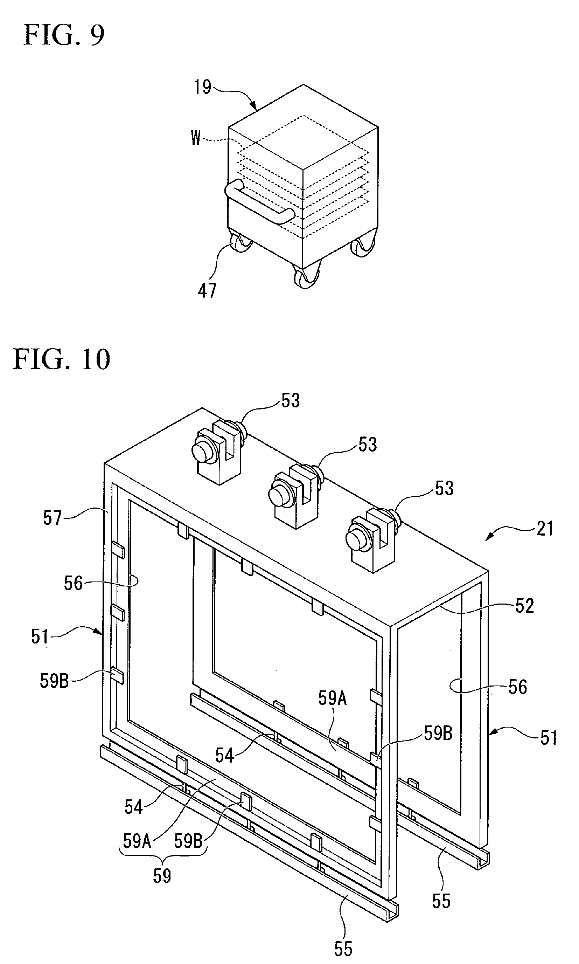

In each substrate replacement chamber 15, the pre-processed substrate W1 is attached to a carrier 21 (refer to FIG. 10), or the post-processed substrate W2 is detached from the carrier 21.

The substrate replacement robot 17 attaches a substrate W to the carrier 21, or removes the substrate from the carrier 21.

Each substrate storage holder 19 is used when substrates W are conveyed to a separate processing chamber which is different in the thin-film solar cell manufacturing apparatus 10, and stores the substrates W.

In addition, in the thin-film solar cell manufacturing apparatus 10 of the first embodiment, four substrate film formation lines 16 each including a film forming chamber 11, a loading-ejecting chamber 13, and a substrate replacement chamber 15 are provided.

Additionally, the substrate replacement robot 17 is movable on rails 18 laid on a floor surface, and a transfer process of the substrates W to all the substrate film formation lines 16 is performed by one substrate replacement robot 17.

Moreover, a substrate film formation module 14 is configured by integrating the film forming chamber 11 and the loading-ejecting chamber 13, and has a size such that the module can be loaded into an autotruck for transportation.

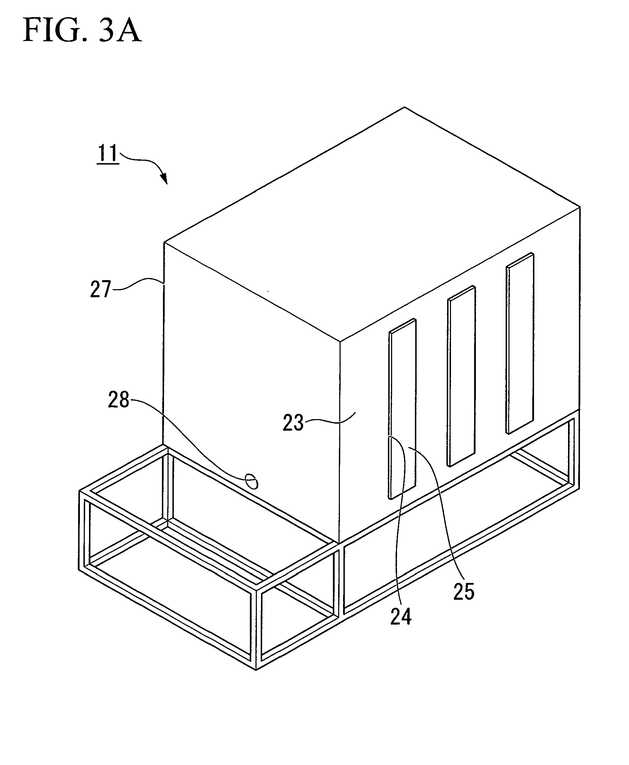

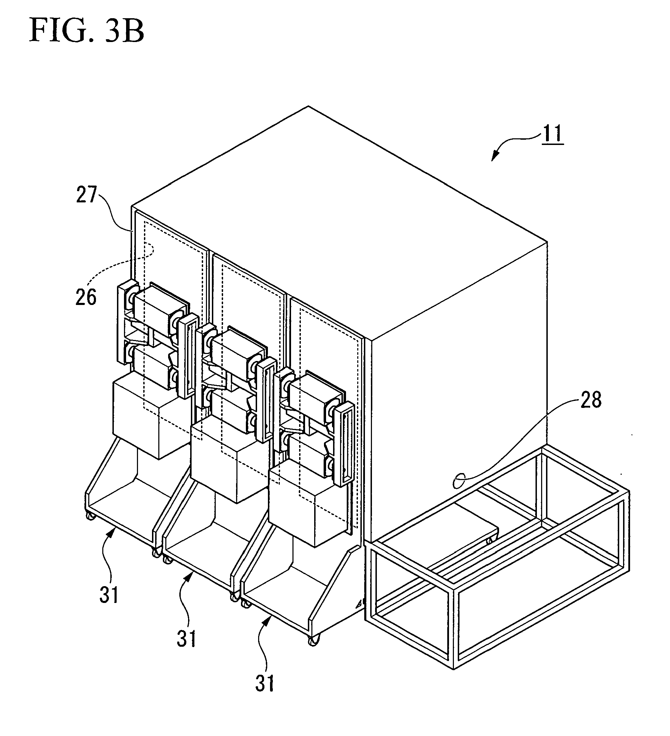

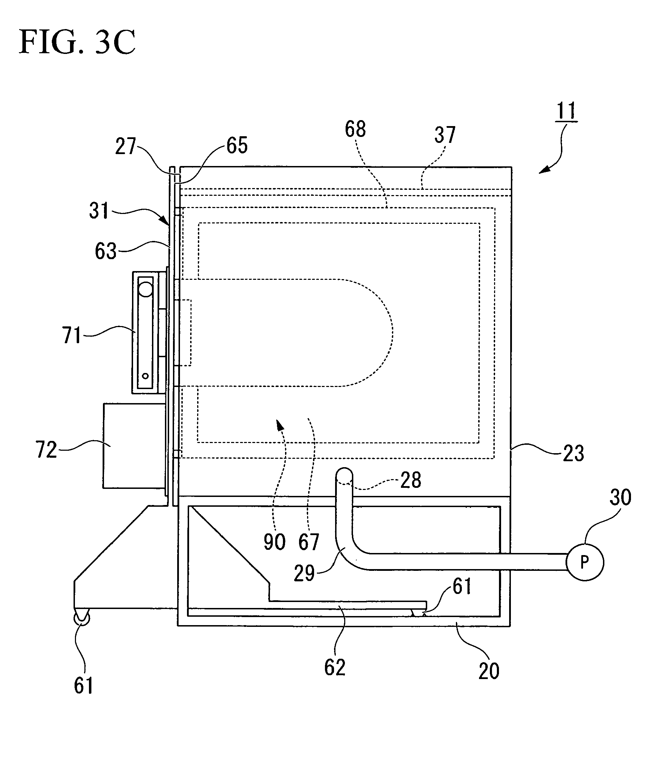

FIGS. 3A to 3C are schematic configuration views of the film forming chamber 11. FIG. 3A is a perspective view, FIG. 3B is a perspective view as seen from an angle different from FIG. 3A, and FIG. 3C is a side view.

As shown in FIGS. 3A to 3C, the film forming chamber 11 is formed in the shape of a box. A lateral surface 23 of the film forming chamber 11 connected to the loading-ejecting chamber 13 is formed with three carrier transfer inlet ports 24 which allow the carrier 21 on which the substrates W are mounted to pass therethrough. The carrier transfer inlet ports 24 are provided with shutters 25 which open and close the carrier transfer inlet ports 24. When a shutter 25 is closed, the carrier transfer inlet port 24 is closed securing airtightness. Three electrode units 31 for forming films on the substrates W are attached to a lateral surface 27 opposite to the lateral surface 23. The electrode units 31 are configured to be attachable to and detachable from the film forming chamber 11. Additionally, a vacuuming pipe 29 for reducing the pressure of the film forming chamber 11 is connected to a lateral lower portion 28 of the film forming chamber 11 so that the film forming chamber has a vacuum atmosphere, and a vacuum pump 30 is connected to the vacuuming pipe 29.

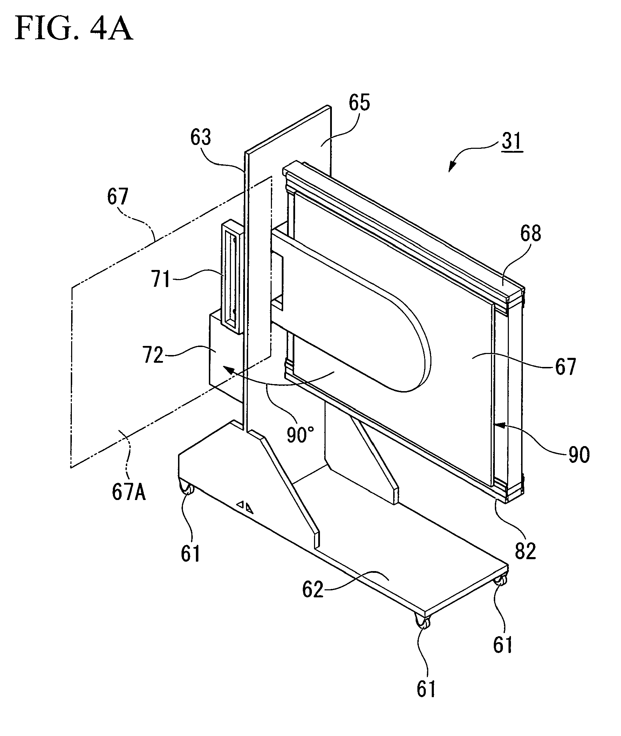

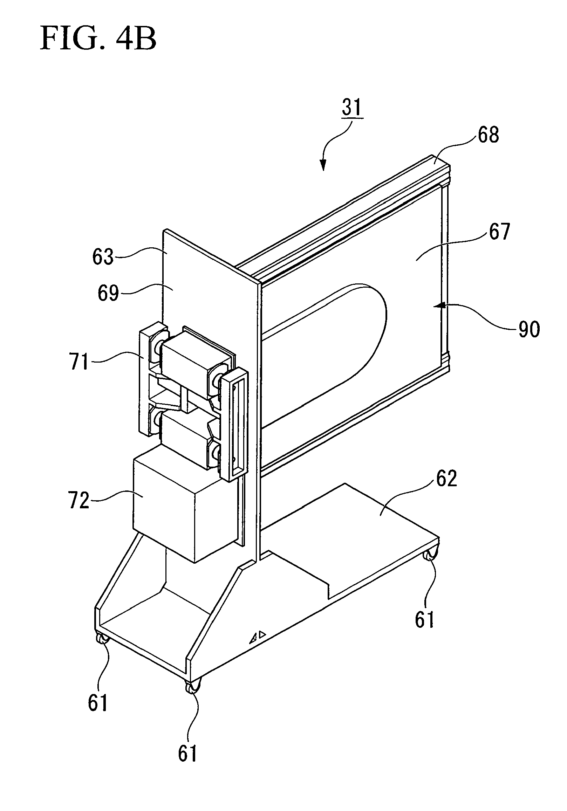

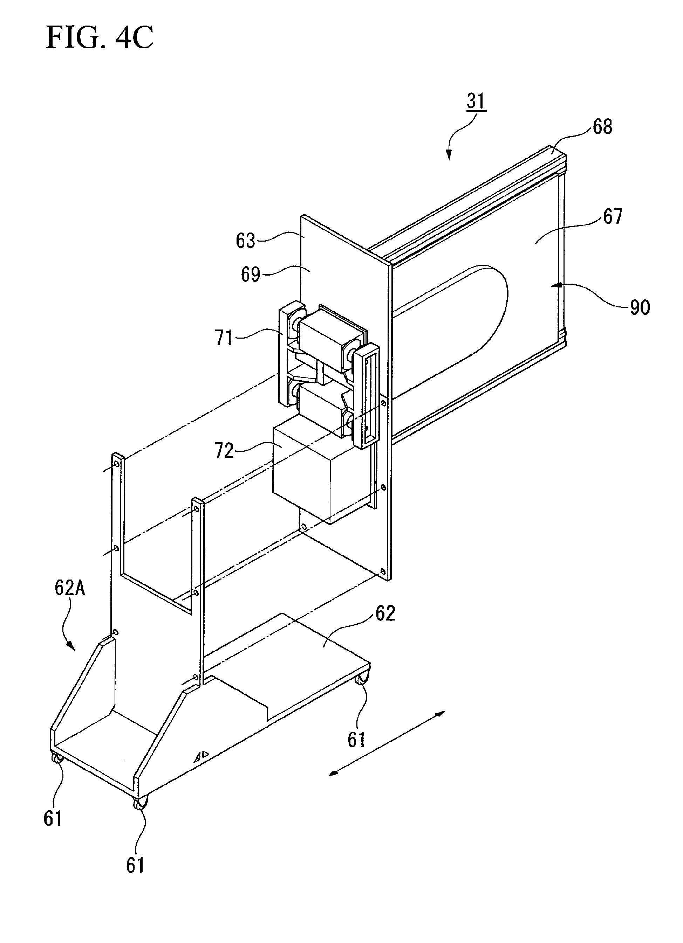

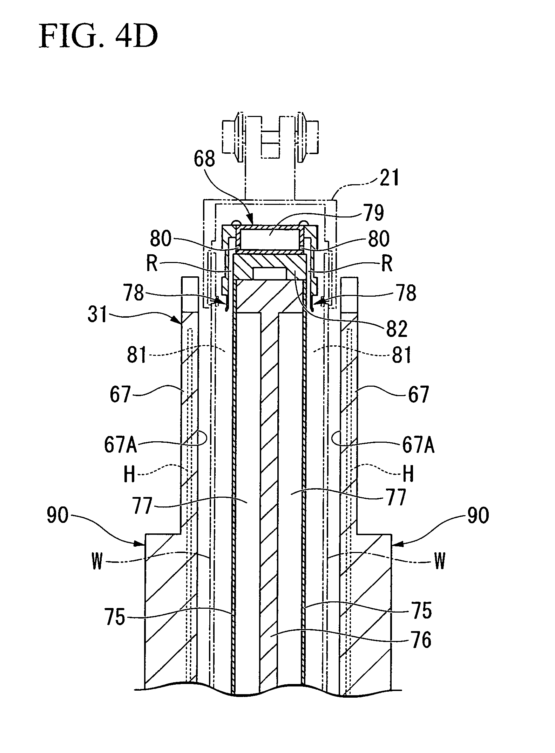

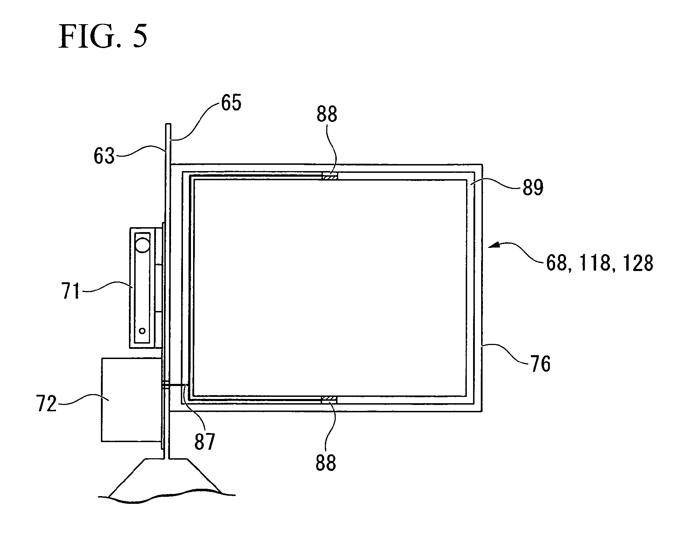

FIGS. 4A to 4D are schematic configuration views of the electrode unit 31. FIG. 4A is a perspective view, FIG. 4B is a perspective view as seen from an angle different from FIG. 4A, FIG. 4C is a perspective view showing a modified example of the electrode unit 31, and FIG. 4D is a sectional view partially showing a cathode unit and an anode (counter electrode). Additionally, FIG. 5 is a plan view of a cathode. The electrode units 31 are attachable to and detachable from three openings 26 formed in the lateral surface 27 of the film forming chamber 11 (refer to FIG. 3B). One of a plurality of wheels 61 is provided at each of the four corners of the lower portion, and the electrode units 31 are movable on the floor surface. On a bottom plate portion 62 to which the wheels 61 are attached, a side plate portion 63 is erected in the vertical direction. The side plate portion 63 has a size such that the side plate portion blocks the opening 26 of the lateral surface 27 of the film forming chamber 11. As shown in the modified example of FIG. 4C, the bottom plate portion 62 with the wheels 61 may be a truck 62A which can be separated from and connected to the electrode unit 31. In this case, the truck 62A can be separated from the electrode unit 31 after the electrode unit 31 is connected to the film forming chamber 11. Therefore, the respective electrode units 31 can be transferred by commonly-used truck 62A, and a plurality of trucks is not used.

The side plate portion 63 forms a part of a wall surface of the film forming chamber 11.

One surface (surface which faces the inside of the film forming chamber 11; first surface) 65 of the side plate portion 63 is provided with anodes 67 and a cathode unit 68 which are located on both surfaces of the substrate W during film formation processing. The electrode unit 31 of the present embodiment includes a pair of anodes 67 arranged so as to be separated from each other at both ends of the cathode unit 68 with the cathode unit 68 therebetween. In the electrode unit 31, films can be simultaneously formed on two substrates W, using one electrode unit 31. Accordingly, respective substrates W during film formation processing are arranged on both sides of the cathode unit 68 so as to become substantially parallel to a direction of gravitational force (vertical direction), and so as to face the cathode unit 68. Two anodes 67 are arranged outside respective substrates W in the thickness direction in a state where each of the anodes face the substrates W.

Additionally, a drive mechanism 71 for driving the anodes 67, and a matching box 72 for feeding electric power to the cathode unit 68 when a film is formed are attached to the other surface 69 (second surface) of the side plate portion 63. Moreover, the side plate portion 63 is formed with a connecting portion for piping (not shown) which supplies film forming gas to the cathode unit 68.

A heater H is built in each anode 67 as a temperature control section for adjusting the temperature of the substrate W. Additionally, the two anodes 67 and 67 are movable in directions (horizontal directions) in which the anodes come close to and separate from each other using the drive mechanism 71 provided at the side plate portion 63, and the distance between each substrate W and the cathode unit 68 is controllable. Specifically, when films are formed on the substrates W, the two anodes 67 and 67 move toward the cathode unit 68, are in contact with the substrate W, and move in directions in which the anodes approach the cathode unit 68, thereby adjusting the distance between the substrates W and the cathode unit 68 as desired. Thereafter, films are formed, and the anodes 67 and 67 move in directions in which the anodes separate from each other after the end of film forming. Since the drive mechanism 71 is provided in this way, the substrates W can be easily taken out of the electrode unit 31. Moreover, each anode 67 is attached to the drive mechanism 71 via a hinge, and can be turned (opened) until the surface 67A of the anode 67 which faces the cathode unit 68 becomes substantially parallel to one surface 65 of the side plate portion 63, in a state in which the electrode unit 31 is pulled out of the film forming chamber 11.

That is, the anode 67 is configured so as to be able to turn by approximately 90° from the vertical direction of the bottom plate portion 62 (refer to FIG. 4A).

The cathode unit 68 has a shower plate 75 (=cathode), a cathode intermediate member 76, a discharge duct 79, a floating capacitance member 82, and a power feeding point 88. The shower plates 75 are arranged on both sides of the cathode unit 68 on the surface of the cathode unit 68 which faces the anodes 67. The shower plate 75 is formed with a plurality of small holes (not shown), and jets the film forming gas toward the substrate W. Moreover, the shower plates 75 and 75 are cathodes (high-frequency electrodes) connected to the matching box. The cathode intermediate member 76 connected to the matching box is provided between the two shower plates 75 and 75. That is, the shower plates 75 are arranged on both sides of the cathode intermediate member 76 in a state where the shower plates come in contact with the cathode intermediate member 76. The cathode intermediate member 76 and the shower plates (cathodes) 75 are formed from electrical conductors, and high frequency is applied to the shower plates (cathodes) 75 via the cathode intermediate member 76. For this reason, voltages of the same electrical potential and phase for generating plasma are applied to the two shower plates 75 and 75.

Here, as shown in FIGS. 4D and 5, the cathode intermediate member 76 is made of one plate, and is connected to a high-frequency power source (not shown) via the matching box 72.

The matching box 72 is a device used in order to obtain the impedance matching between the cathode intermediate member 76 and the high-frequency power source, and is provided on the other surface 69 (second surface) of the side plate portion 63 of the electrode unit 31.

Additionally, a total of two power feeding points 88 are each disposed on upper and lower lateral surfaces (a top lateral surface and a bottom lateral surface or an upper portion and a lower portion) of the cathode intermediate member 76 in the height direction (longitudinal direction of the side plate portion 63). Therefore, the voltage supplied from the high-frequency power source via the matching box 72 is applied to the cathode intermediate member 76 via the power feeding points 88.

A wiring line 87 for electrically connecting both 88 and 72 together is wired between the power feeding points 88 and the matching box 72.

The wiring line 87 extends from the matching box 72, and is wired to the power feeding points 88 and 88 along the periphery of the cathode intermediate member 76.

In addition, the periphery of the cathode intermediate member 76, the power feeding points 88, and the wiring line 87 are surrounded by an the insulating member 89 made of, for example, alumina or quartz.

The cathode intermediate member 76 and the shower plates (cathodes) 75 are formed from electrical conductors, and high frequency is applied to the shower plates (cathodes) 75 via the cathode intermediate member 76.

For this reason, voltages of the same electrical potential and phase for generating plasma are applied to the two shower plates 75 and 75.

Additionally, space portions 77 are formed between the cathode intermediate member 76 and the shower plates 75. The space portions 77 are separated from each other by the cathode intermediate member 76, and are individually formed so as to correspond to the shower plates 75 and 75, respectively. That is, the cathode unit 68 is formed with a pair of space portions 77.

When the film forming gas is introduced into each of the space portions 77 from a gas supply device (not shown), the gas is released from the shower plates 75 and 75, respectively. That is, the space portion 77 has a role as a gas supply passage.

In the first embodiment, the respective space portions 77 are separately formed so as to correspond to the shower plates 75 and 75, respectively. Thus, the cathode unit 68 has two-system gas supply passages. Therefore, the kind of gas, the flow rate of gas, the mixing ratio of gas, and the like are independently controlled for every system.

Moreover, a hollow discharge duct 79 is provided at a peripheral edge portion of the cathode unit 68 over its whole periphery.

The discharge duct 79 is formed with a vacuuming port 80 for sucking and removing (evacuating) the film forming gas or reactive products (powder) of a film formation space 81.

Specifically, the vacuuming port 80 is formed so as to communicate with the film formation space 81 formed between the substrate W and the shower plate 75 when a film is formed.

A plurality of vacuuming ports 80 is formed along the peripheral edge portion of the cathode unit 68, and is configured so that the film forming gas or reactive products (powder) can be sucked and removed substantially equally over its whole periphery.

Additionally, the surface of the discharge duct 79 which faces the inside of the film forming chamber 11 at the lower portion of the cathode unit 68 is formed with an opening (not shown). The film forming gas removed through the vacuuming ports 80 can be discharged into the film forming chamber 11 via this opening.

The gas discharged into the film forming chamber 11 is evacuated to the outside through the vacuuming pipe 29 provided at the lateral lower portion 28 of the film forming chamber 11.

Additionally, the floating capacitance member 82 which has a dielectric body and/or a laminated space is provided between the discharge duct 79 and the cathode intermediate member 76. The discharge duct 79 is connected to the ground potential. The discharge duct 79 also functions as a shield frame for preventing abnormal electrical discharge from the cathode 75 and the cathode intermediate member 76.

Moreover, masks 78 are provided at the peripheral edge portion of the cathode unit 68 so as to cover the part from the peripheral portion of the discharge duct 79 to the peripheral portion of the shower plate 75.

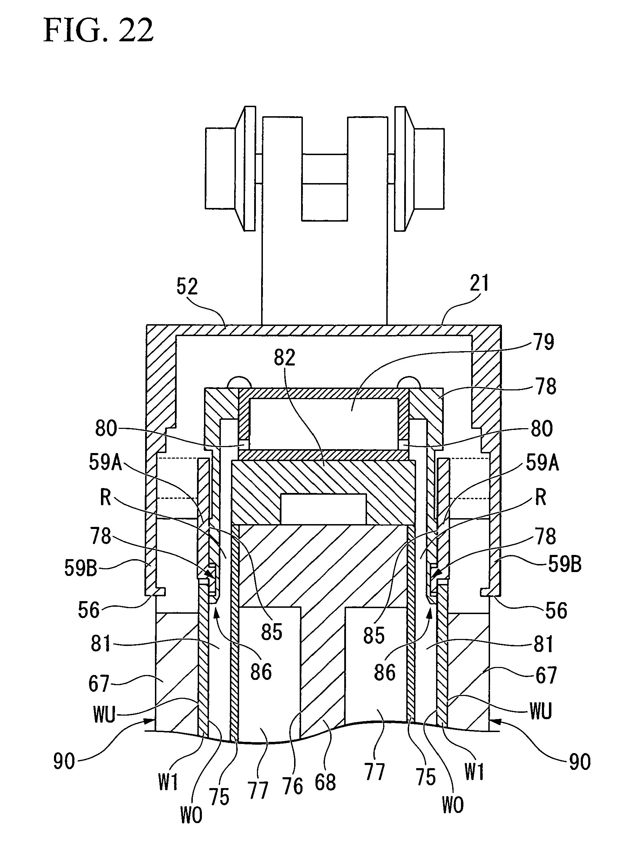

Each mask 78 covers a holding piece 59A (refer to FIGS. 10 and 22) of a holding portion 59 (which will be described later) provided at the carrier 22, and forms a gas flow passage R for guiding the film forming gas or reactive products (powder) of the space portion 77 to the discharge duct 79, integrally with the holding piece 59A when a film is formed.

That is, the gas flow passage R is formed between the mask 78 which covers the carrier 21 (holding piece 59A), and the shower plate 75 or the discharge duct 79.

Returning to FIG. 2, transfer rails 37 are laid between the film forming chamber 11 and the substrate replacement chamber 15 so that the carrier 21 can be transferred between the film forming chamber 11 and the loading-ejecting chamber 13 and between the loading-ejecting chamber 13 and the substrate replacement chamber 15.

In addition, the transfer rails 37 are separated between the film forming chamber 11 and the loading-ejecting chamber 13, and the carrier transfer inlet ports 24 can be sealed by closing the shutters 25.

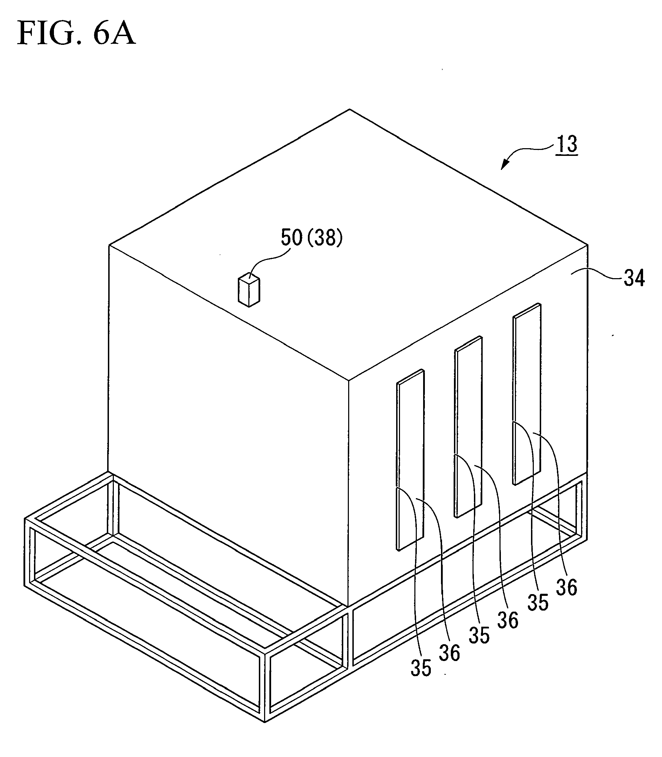

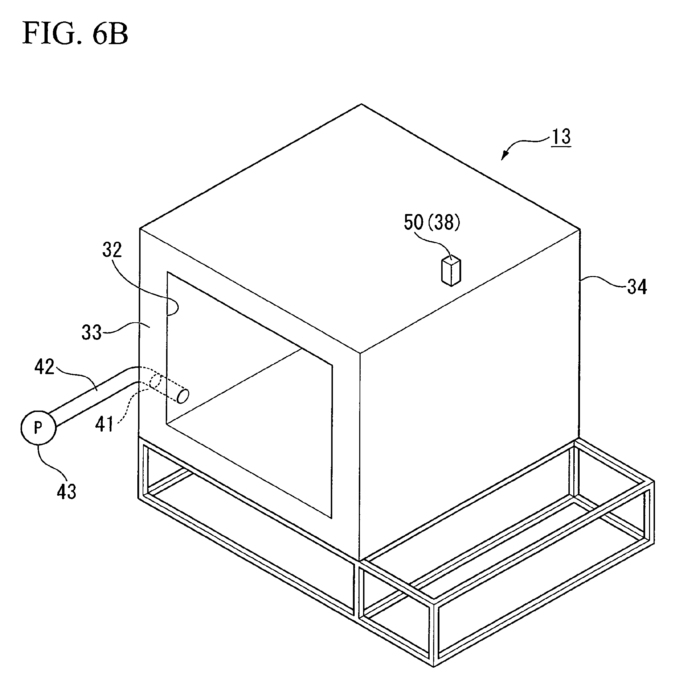

FIGS. 6A and 6B are schematic configuration views of the loading-ejecting chamber 13, and FIG. 6A is a perspective view, and FIG. 6B is a perspective view as seen from an angle different from the angle of FIG. 6A.

As shown in FIGS. 6A and 6B, the loading-ejecting chamber 13 is formed in the shape of a box.

A lateral surface 33 is connected to the lateral surface 23 of the film forming chamber 11 securing airtightness.

The lateral surface 33 is formed with an opening 32 through which three carriers 21 can be inserted.

A lateral surface 34 which is opposite to the lateral surface 33 is connected to the substrate replacement chamber 15.

The lateral surface 34 is formed with three carrier transfer inlet ports 35 which allow the carrier 21 on which the substrates W are mounted to pass therethrough.

Each carrier transfer inlet port 35 is provided with a shutter 36 which can secure airtightness. In addition, the transfer rails 37 are separated between the loading-ejecting chamber 13 and the substrate replacement chamber 15, and the carrier transfer inlet ports 35 can be sealed by closing the shutters 36.

Additionally, the loading-ejecting chamber 13 is provided with a push-pull mechanism 38 for transferring the carrier 21 between the film forming chamber 11 and the loading-ejecting chamber 13 along the transfer rails 37.

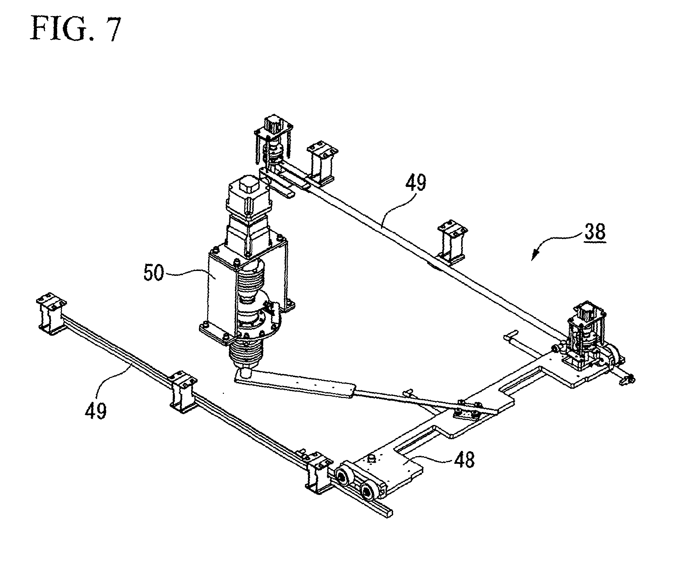

As shown in FIG. 7, the push-pull mechanism 38 includes a locking portion 48 for locking the carrier 21; a pair of guide members 49 provided at both ends of the locking portion 48 and disposed substantially parallel to the transfer rails 37; and a transfer device 50 for moving the locking portion 48 along both of the guide members 49.

Moreover, a transfer mechanism (not shown) for transferring the carrier 21 by a predetermined distance in a direction substantially orthogonal to the direction in which the transfer rails 37 are laid in plan view (when the surface on which the loading-ejecting chamber 13 is installed is seen from the vertical direction), is provided within the loading-ejecting chamber 13 in order to simultaneously store the pre-processed substrate W1 and the post-processed substrate W2.

A vacuuming pipe 42 for reducing the pressure inside of the loading-ejecting chamber 13 is connected to a lateral lower portion 41 of the loading-ejecting chamber 13 so that the chamber has a vacuum atmosphere, and a vacuum pump 43 is connected to the vacuuming pipe 42.

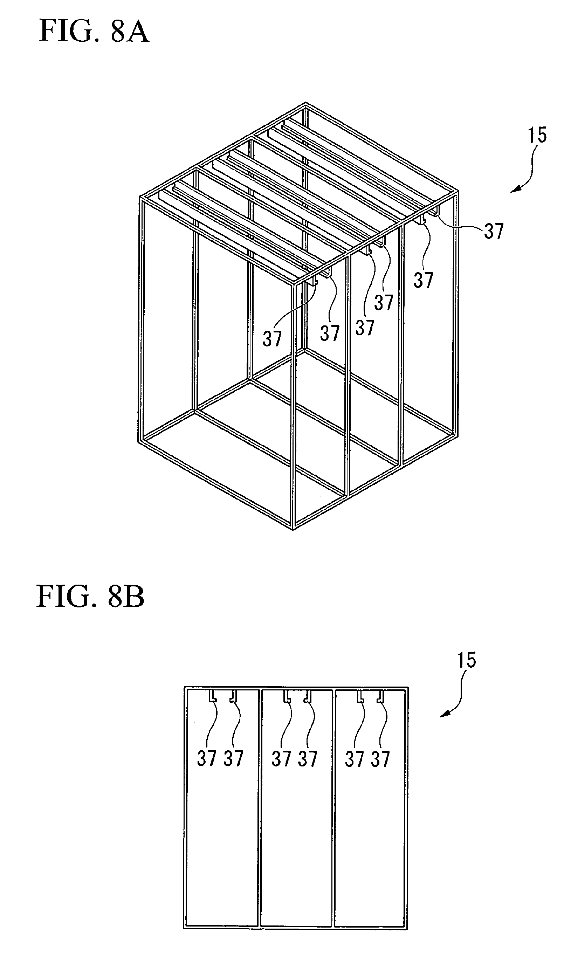

FIGS. 8A and 8B are schematic configuration views of the substrate replacement chamber, FIG. 8A is a perspective view, and FIG. 8B is a front view.

As shown in FIGS. 8A and 8B, the substrate replacement chamber 15 is formed in the shape of a frame, and is connected to the lateral surface 34 of the loading-ejecting chamber 13.

In the substrate replacement chamber 15, the pre-processed substrates W1 can be attached to the carrier 21 disposed at the transfer rails 37, and the post-processed substrate W2 can be removed from the carrier 2.

Three carriers 21 are configured to be able to be arranged in parallel at the substrate replacement chamber 15.

The substrate replacement robot 17 has a drive arm 45, and has a suction portion which sucks the substrate W on the tip of the drive arm 45 (refer to FIG. 2).

Additionally, the drive arm 45 is driven between the carrier 21 and the substrate storage holder 19 which are disposed at the substrate replacement chamber 15. Specifically, the drive arm 45 can take out the pre-processed substrate W1 from the substrate storage holder 19, and attach the pre-processed substrate W1 to the carrier 21 disposed at the substrate replacement chamber 15, and can remove the post-processed substrate W2 from the carrier 21 which has returned to the substrate replacement chamber 15, and convey the substrate to the substrate storage holder 19.

FIG. 9 is a perspective view of the substrate storage holder.

As shown in FIG. 9, the substrate storage holder 19 is formed in the shape of a box, and has a size such that the holder can store a plurality of substrates W.

A plurality of substrates W can be stored in a stacked manner in the up-and-down direction within the substrate storage holder 19 in a state where the surfaces to be film-formed of the substrates W are made horizontal.

Additionally, casters 47 are provided at a lower portion of the substrate storage holder 19 so as to allow for movement to separate processing apparatuses different from the thin-film solar cell manufacturing apparatus 10.

FIG. 10 is a perspective view of the carrier 21. As shown in FIG. 10, the carrier 21 is used to convey the substrates W, and includes two frame-like frames 51 to which the substrates W can be attached. That is, two substrates W can be attached in one carrier 21. Two frames 51 and 51 are integrated together by a connection member 52 at the upper portions thereof.

Additionally, wheels 53 to be placed on the transfer rails 37 are provided above the connection member 52. When the wheels 53 roll on the transfer rails 37, the carrier 21 is movable along the transfer rails 37.

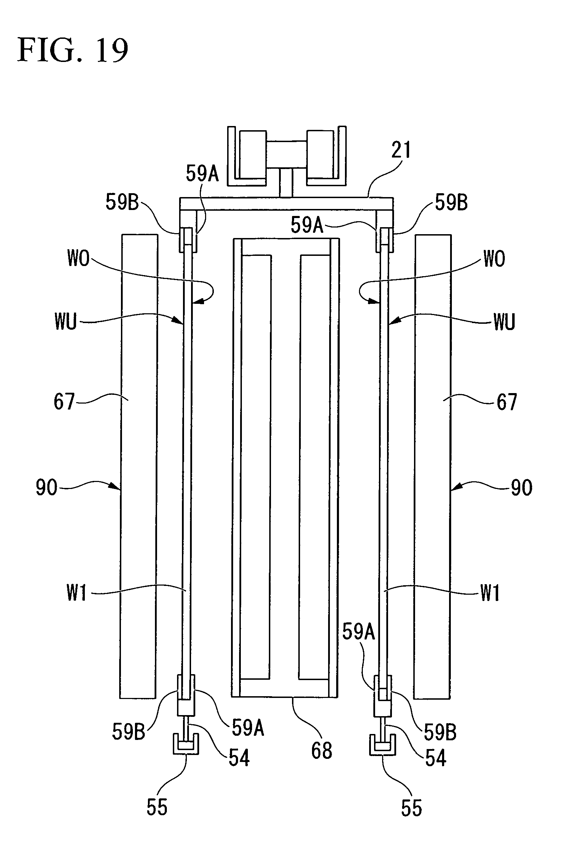

Additionally, a lower portion of each frame 51 is provided with a frame holder 54 for suppressing the shaking of the substrate W when the carrier 21 is transferred. The tip of the frame holder 54 is fitted into a rail member 55 (refer to FIG. 19) formed in a recessed shape in a cross-section, the rail member 55 being provided on the bottom surface of each chamber. In addition, the rail members 55 are disposed in a direction along the transfer rails 37 in plan view (when the surface on which the rail members 55 are installed is seen from the vertical direction).

Additionally, the carrier 21 can be more stable if the frame holder 54 is constituted of a plurality of rollers.

Each frame 51 has an opening 56, a peripheral edge portion 57 and a holding portion 59. When the substrate W is mounted to the frame 51, the surface to be film-formed of the substrate W is exposed at the opening 56. Additionally, both surfaces of the substrate W are held by the peripheral edge portion 57 of the opening 56 and the holding portion 59, and the substrate W is fixed to the frame 51. A biasing force caused by a spring or the like acts on the holding portion 59 which holds the substrate W.

Additionally, the holding portion 59 has holding pieces 59A and 59B which is to contact the front surface WO (surface to be film-formed) and rear surface WU (back surface) of the substrate W (refer to FIG. 22). The separation distance between the holding pieces 59A and 59B is variable via the spring or the like, that is, the holding piece 59A is configured to be movable along the directions in which the holding piece comes close to and separates from the holding piece 59B according to the movement of the anode 67 (the details of which will be described later).

Here, one carrier 21 is attached on one transfer rail 37. That is, one carrier 21 which can hold a pair of substrates (two substrates in total) is attached onto one transfer rail 37. That is, in a set of thin-film solar cell manufacturing apparatuses 10, three carriers 21 are attached, that is, three pairs of substrates (six substrates in total) are held.

In the thin-film solar cell manufacturing apparatus 10 of the first embodiment, four substrate film formation lines 16 each constituted of the above-described film forming chamber 11, a loading-ejecting chamber 13, and a substrate replacement chamber 15 are arranged (refer to FIG. 2), and three carriers 21 are stored in one film forming chamber (refer to FIGS. 3A and 3B). Therefore, films can be substantially simultaneously formed on twenty four substrates W.

### (Method for Manufacturing Thin-film Solar Cell)

Next, a method for forming a film on a substrate W will be described using the thin-film solar cell manufacturing apparatus 10 of the first embodiment. In addition, although this description is made using drawings of one substrate film formation line 16, films are formed on substrates by substantially the same method as the method described below in the other three substrate film formation lines 16.

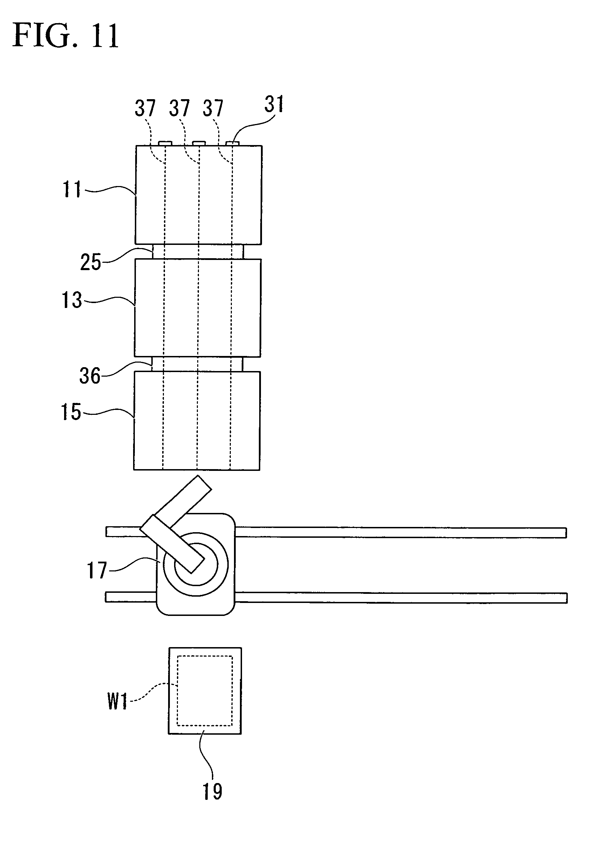

First, as shown in FIG. 11, the substrate storage holder 19 which stores a plurality of pre-processed substrates W1 is arranged at a predetermined position.

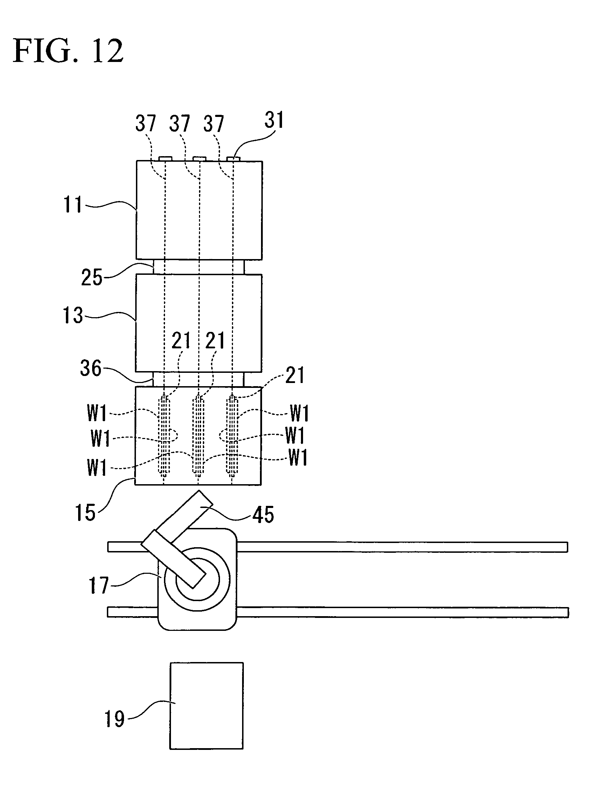

Next, as shown in FIG. 12, the drive arm 45 of the substrate replacement robot 17 is operated to take one pre-processed substrate W1 out of the substrate storage holder 19, and attaches the pre-processed substrate W1 to a carrier 21 installed within the substrate replacement chamber 15. At this time, the arrangement direction of the pre-processed substrate W1 which has been arranged in the horizontal direction in the substrate storage holder 19 varies in the vertical direction, and the pre-processed substrate W1 is attached to the carrier 21. This operation is repeated once again to attach two pre-processed substrates W1 to one carrier 21.

Moreover, this operation is repeated to attach the pre-processed substrates W1 with each of the remaining two carriers 21 installed within the substrate replacement chamber 15. That is, six pre-processed substrates W1 are attached in this step.

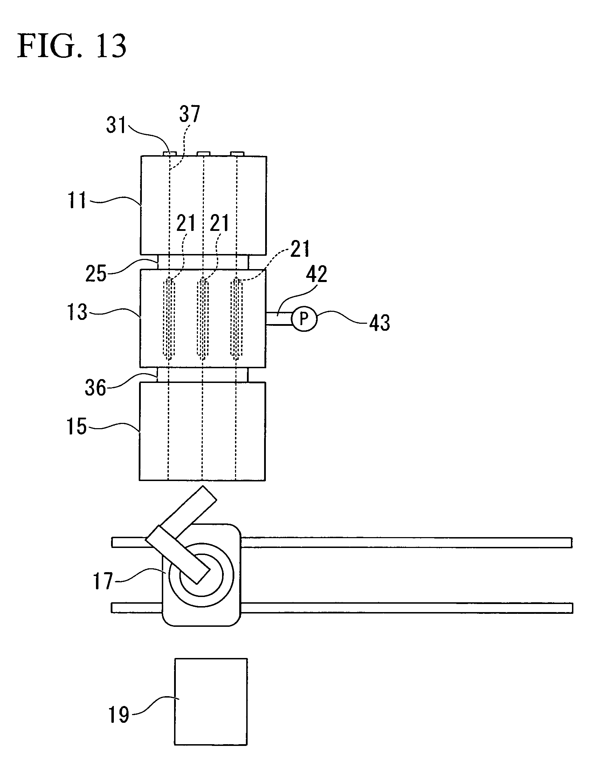

Subsequently, as shown in FIG. 13, the three carriers 21 to which the pre-processed substrates W1 are attached are substantially simultaneously transferred along the transfer rails 37, and are stored within the loading-ejecting chamber 13. After the carriers 21 are stored within the loading-ejecting chamber 13, the shutters 36 of the carrier transfer inlet ports 35 of the loading-ejecting chamber 13 are closed.

Thereafter, the inside of the loading-ejecting chamber 13 is held in a vacuum state using the vacuum pump 43.

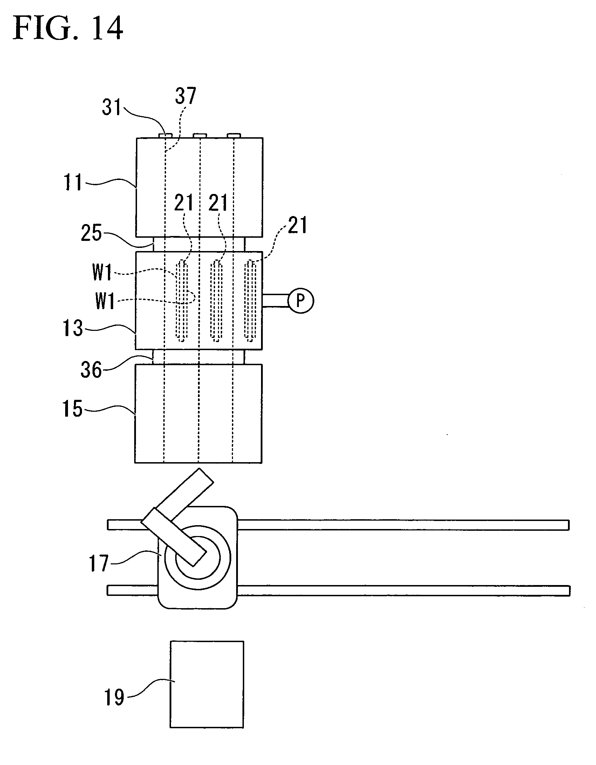

Thereafter, as shown in FIG. 14, the three carriers 21 are transferred using the transfer mechanism by a predetermined distance, respectively, in a direction orthogonal to a direction in which the transfer rails 37 are laid in plan view (when the surface on which the loading-ejecting chamber 13 is installed is seen from the vertical direction).

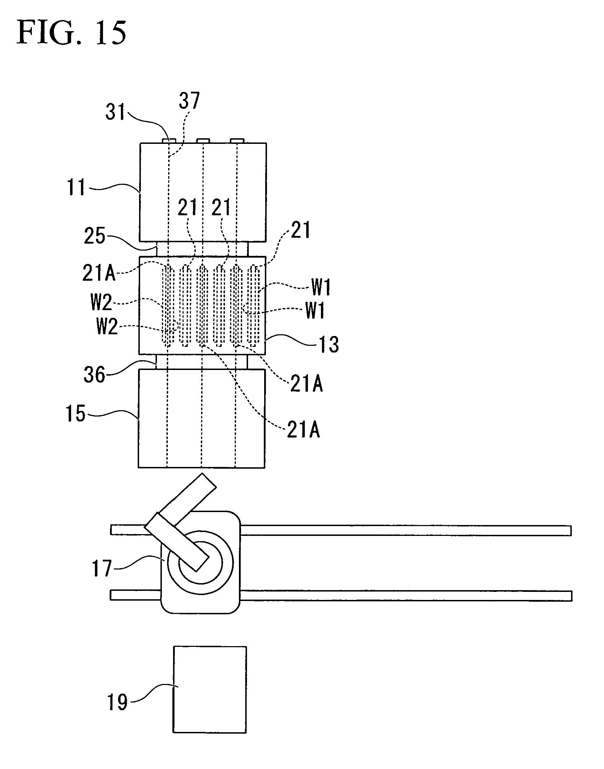

Next, as shown in FIG. 15, the shutters 25 of the film forming chamber 11 are opened, and the carriers 21A to which the post-processed substrates W2 that has been film-forming processed in the film forming chamber 11 are attached are transferred into the loading-ejecting chamber 13, using the push-pull mechanism 38.

At this time, in plan view, the carrier 21 to which the pre-processed substrates W1 are attached, and the carrier 21A to which the post-processed substrate W2 are attached are arranged in parallel.

By holding this state for a predetermined time, the heat which is accumulated in the post-processed substrates W2 is transferred to the pre-processed substrates W1. That is, the substrates W1 before film forming are heated.

Here, the operation of the push-pull mechanism 38 will be described. In addition, the operation when the carriers 21A located within the film forming chamber 11 are transferred into the loading-ejecting chamber 13 will be described here.

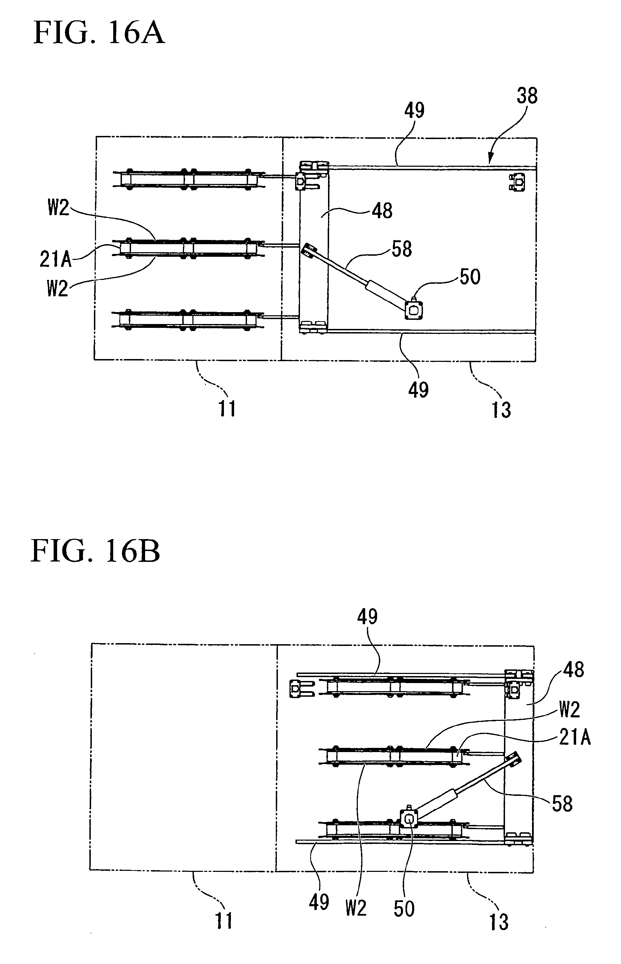

As shown in FIG. 16A, the carriers 21A to which the post-processed substrates W2 are attached are locked to the locking portion 48 of the push-pull mechanism 38. Then, the transfer arm 58 of the transfer device 50 attached to the locking portion 48 is swung. At this time, the length of the transfer arm 58 is variable. Then, the locking portion 48 to which the carriers 21A have been locked moves while being guided by the guide members 49, and as shown in FIG. 16B, moves into the loading-ejecting chamber 13. That is, the carriers 21A are transferred to the loading-ejecting chamber 13 from the film forming chamber 11.

According to such a configuration, it becomes unnecessary to provide a drive source (drive mechanism) for driving the carriers 21A within the film forming chamber 11.

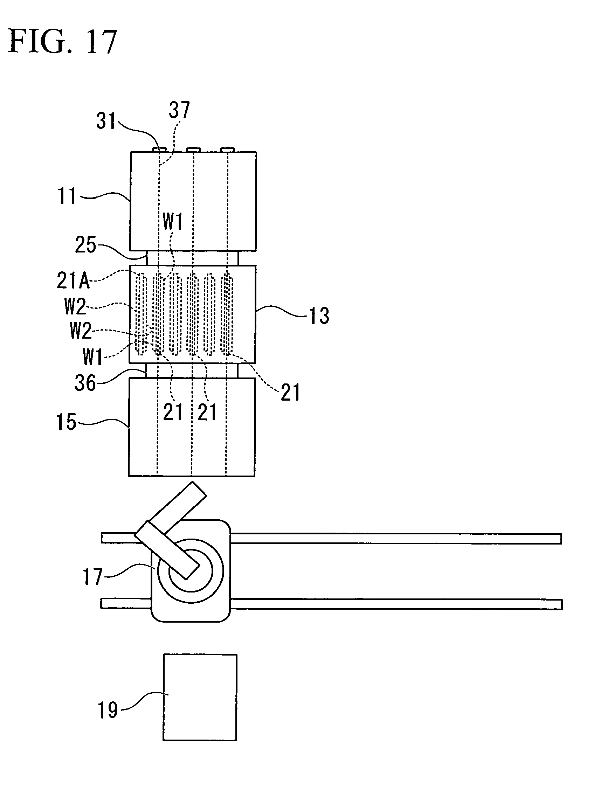

Next, as shown in FIG. 17, the carriers 21 and the carriers 21A are transferred in a direction orthogonal to the transfer rails 37 by the transfer mechanism, and the respective carriers 21 holding the pre-processed substrates W1 are transferred to the positions of the respective transfer rails 37.

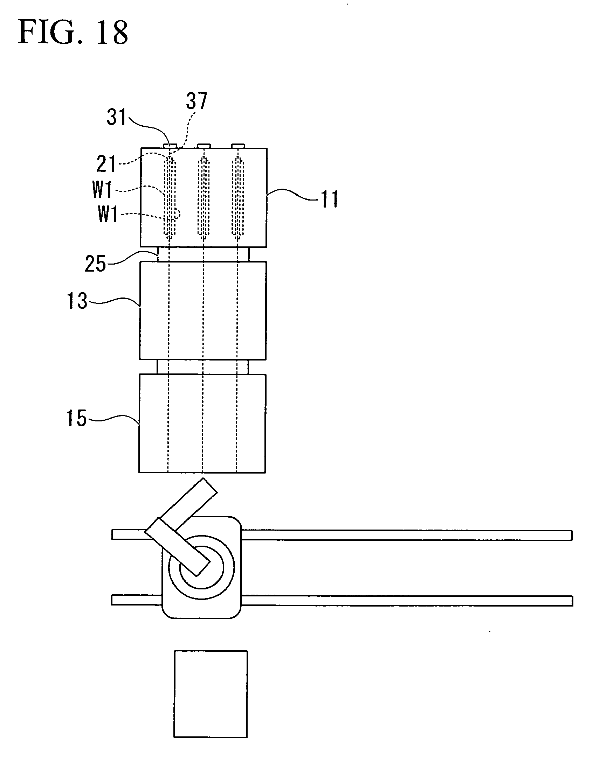

Subsequently, as shown in FIG. 18, the carriers 21 holding the pre-processed substrates W1 are transferred to the film forming chamber 11, using the push-pull mechanism 38, and the shutters 25 are closed after the completion of transfer. In addition, the film forming chamber 11 is held in a vacuum state.

At this time, the pre-processed substrates W1 attached to the carrier 21 move along a direction parallel to the surfaces thereof, and are inserted between the anodes 67 and the cathode unit 68 within the film forming chamber 11 in a state along the vertical direction so that the front surfaces WO become substantially parallel to the direction of gravitational force (refer to FIG. 19).

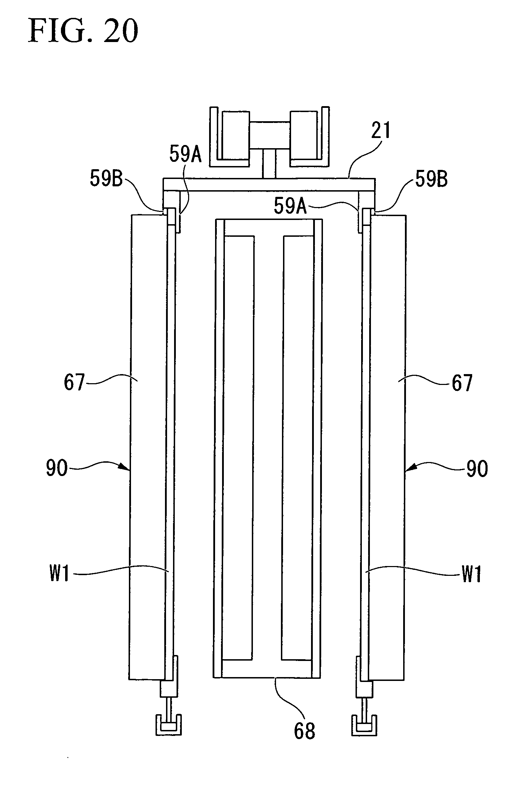

Next, as shown in FIGS. 19 and 20, the two anodes 67 and the rear surfaces WU of the pre-processed substrates W1 are in contact with each other by moving the anodes 67 of the electrode unit 31 in directions in which the anodes approach each other using the drive mechanism 71.

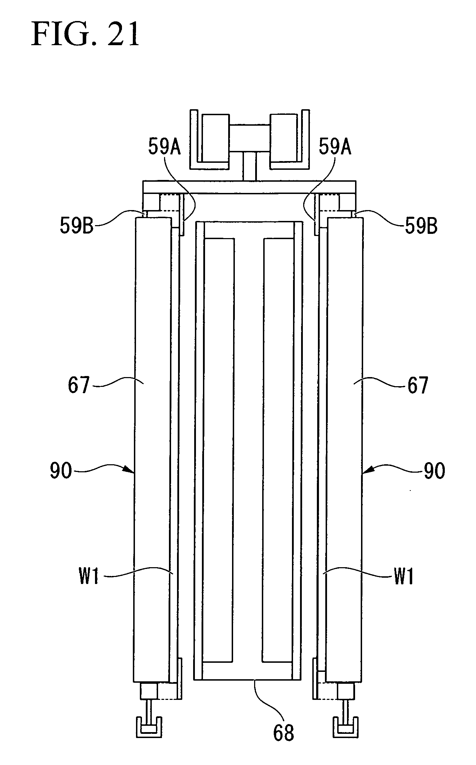

As shown in FIG. 21, when the drive mechanism 71 is further driven, the pre-processed substrates W1 move toward the cathode unit 68 so as to be pushed by the anodes 67.

Moreover, the pre-processed substrates W1 are moved until the gap between the pre-processed substrate W1 and the shower plate 75 of the cathode unit 68 reaches a predetermined distance (film forming distance).

In addition, the gap (film forming distance) between the pre-processed substrate W1 and the shower plate 75 of the cathode unit 68 is 5 to 15 mm, and is, for example, approximately 5 mm.

At this time, the holding piece 59A of the holding portion 59 of the carrier 21 which is in contact with the front surface WO of the pre-processed substrate W1 is displaced in a direction away from the holding piece 59B along with the movement (movement of the anode 67) of the pre-processed substrate W1. The substrate W1 before film forming at this time is held by the anode 67 and the holding piece 59A. In addition, when the anode 67 has moved in the direction away from the cathode unit 68, since the restoring force of a spring or the like acts on the holding piece 59A, the holding piece 59A is displaced toward the holding piece 59B.

When the pre-processed substrate W1 moves toward the cathode unit 68, the holding piece 59A is in contact with the mask 78, and the movement of the anode 67 stops at this time (refer to FIG. 22).

As shown in FIG. 22, the mask 78 is formed so as to cover the surface of the holding piece 59A and the outer-edge portion of the glass substrate W and come into close contact with the holding piece 59A or the outer-edge portion of the substrate W. The film formation space 81 is formed by the mask 78, the shower plate 75 of the cathode unit 68, and the pre-processed substrate W1 (substrate W).

That is, the mask 78 covers an exposure surface 85 of the holding pieces 59A of the carrier 21 which is exposed to the film formation space 81, thereby shielding the holding piece 59A so as not to be exposed to the film formation space 81.

Moreover, a mating surface (contacting surface) between the mask 78 and the holding piece 59A and a mating surface (contacting surface) between the mask 78 and the outer-edge portion of the substrate W functions as a seal portion 86. This prevents the film forming gas from leaking out from between the mask 78 and the holding piece 59A or from between the mask 78 and the outer-edge portion of the substrate W.

Additionally, since the movement of the pre-processed substrate W1 stops when the holding piece 59A or the outer-edge portion of the substrate W is in contact with the mask 78, the gap between the mask 78 and the shower plate 75 and the gap between the mask 78 and the discharge duct 79, that is, the flow passage height of the gas flow passage R in its thickness direction (direction vertical to the plane of the shower plate 75) is set so that the gap between the pre-processed substrate W1 and the cathode unit 68 becomes a predetermined distance.

Additionally, as a modified example of the first embodiment, a structure can be adopted in which the distance between the substrate and the shower plate 75 (=cathode) can also be optionally changed due to the stroke of the drive mechanism 71 by attaching the mask to the discharge duct 79 via an elastic body.

In the above embodiment, a case where the mask 78 and the substrate W are in contact with each other has been described. However, the mask 78 and the substrate W may be arranged so as to leave a very small gap which limits the passage of the film forming gas.

Subsequently, the film forming gas is jetted from the shower plate 75 of the cathode unit 68, and the matching box 72 is started to apply a voltage from the high-frequency power source to the shower plate (=cathode) 75 via the matching box 72 and the cathode intermediate member 76 of the cathode unit 68. At this time, the phases of respective voltages at two power feeding points 88 are matched with each other by the matching box 72.

As the phases of the voltages at the respective power feeding points 88 match each other, the electrical potential of the whole shower plate (cathode) 75 can be uniformly set.

Then, a film is formed on the front surface WO of the pre-processed substrate W1 by applying a voltage to the shower plate (cathode) 75 of the cathode unit 68.

In addition, the pre-processed substrate W1 is heated to a desired temperature by the heater H built in the anode 67.

The anode 67 stops heating when the pre-processed substrate W1 reaches a desired temperature.

Plasma is generated within the film formation space 81 by applying a voltage to the shower plate 75. Even if the heating of the anode 67 is stopped, there is a possibility that the temperature of the pre-processed substrate W1 may rise higher than a desired temperature due to the heat input from the plasma with the passage of time. In this case, the anode 67 can also be made to function as a radiator plate for cooling the pre-processed substrate W1 of which the temperature has risen excessively. Accordingly, the temperature of the pre-processed substrate W1 is adjusted to a desired temperature irrespective of the passage of the film formation processing time.

In addition, a plurality of layers can be film-formed on the substrate W through one film formation processing process by switching a film forming gas material to be supplied from the shower plate 75 at each predetermined time.

Additionally, during film forming and after film forming, the gas or reactive products (powder) within the film formation space 81 is sucked and removed (evacuated) through the vacuuming ports 80 formed in the peripheral edge portion of the cathode unit 68. Specifically, the gas or reactive products within the film formation space 81 is evacuated to the discharge duct 79 of the peripheral edge portion of the cathode unit 68 via the gas flow passage R and the vacuuming ports 80. Thereafter, the gas or reactive products pass through an opening formed in the surface of the discharge duct 79 which faces the inside of the film forming chamber 11 at the lower portion of the cathode unit 68. The gas or reactive products are evacuated to the outside of the film forming chamber 11 through the vacuuming pipe 29 provided at the lateral lower portion 28 of the film forming chamber 11.

In addition, the reactive products (powder) generated when a film is formed can be collected and disposed of when the reactive products are made to adhere to and be deposited on the inner wall surface of the discharge duct 79.

Since the same processing as the above-described processing is executed in all the electrode units 31 in the film forming chamber 11, films can be simultaneously formed on all six substrates.

When the film formation is ended, the two anodes 67 are moved in directions in which the anodes 67 are separated from each other using the drive mechanism 71, and the post-processed substrates W2 and the frames 51 (holding pieces 59A) are returned to their original positions (refer to FIGS. 20 and 22). That is, when the film formation is ended and the carrier 21 is transferred, the masks 78 are removed through the exposure surfaces 85 of the holding pieces 59A. Moreover, by moving the two anodes 67 in directions in which the anodes 67 are separated from each other, the post-processed substrates W2 are separated from the anodes 67 (refer to FIG. 19).

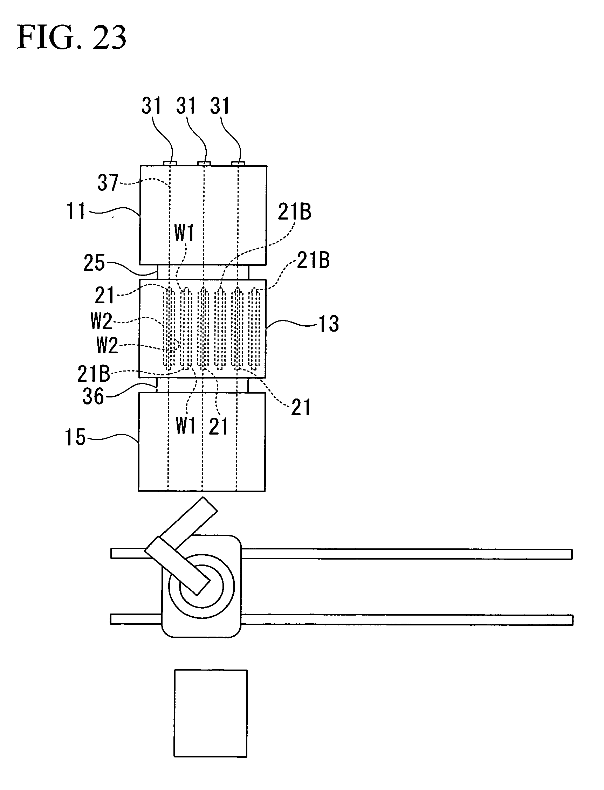

Next, as shown in FIG. 23, the shutters 25 of the film forming chamber 11 are opened, and the carrier 21 is transferred to the loading-ejecting chamber 13, using the push-pull mechanism 38.

At this time, the inside of the loading-ejecting chamber 13 is maintained in a vacuum state, and the carriers 21B to which the pre-processed substrates W1 to be film-formed next are already arranged.

Then, the heat accumulated in the post-processed substrates W2 is transferred to the pre-processed substrates W1 within the loading-ejecting chamber 13, and the temperature of the post-processed substrates W2 is lowered.

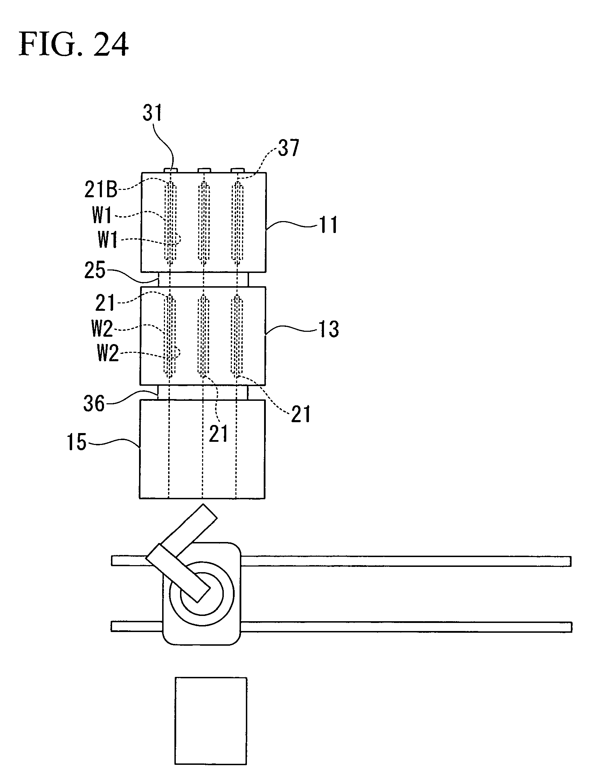

Subsequently, as shown in FIG. 24, after each carrier 21B is transferred into the film forming chamber 11, each carrier 21 is returned to the position of the transfer rails 37 by the transfer mechanism.

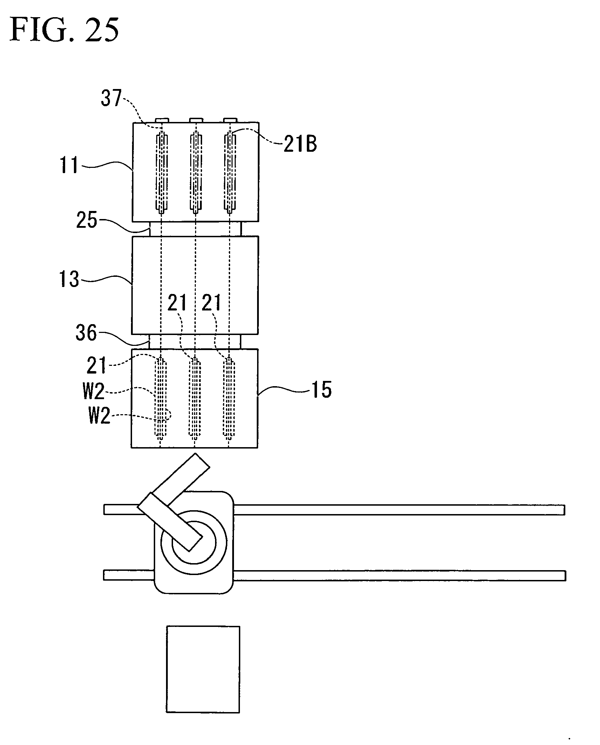

Next, as shown in FIG. 25, after the shutters 25 are closed, the shutters 36 are opened, and the carriers 21 are transferred to the substrate replacement chamber 15.

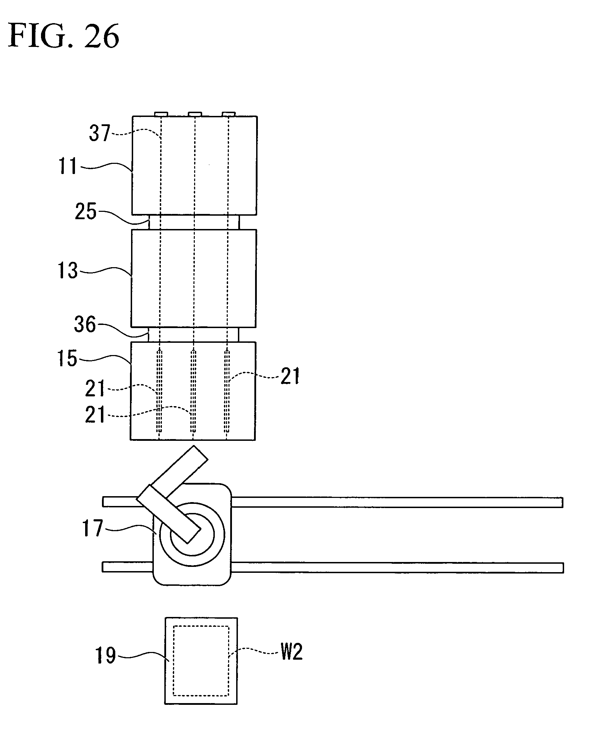

Next, as shown in FIG. 26, each post-processed substrate W2 is removed from the carrier 21 by the substrate replacement robot 17 in the substrate replacement chamber 15, and is conveyed to the substrate storage holder 19.

When removal of all the post-processed substrates W2 is completed, the film formation processing is ended by moving the substrate storage holder 19 to a place (apparatus) where the following process is performed.

In the above film formation processing, when a film on the post-processed substrate W2 is not uniformly formed as a whole, that is, when a film has been nonuniformly formed on the post-processed substrate W2, for example, due to nonuniform or unstable plasma of the two film formation spaces, the phase of a voltage input to one power feeding point 88 in the cathode intermediate member 76, and the phase of a voltage input to the other power feeding point 88 may be shifted by adjusting the operating conditions of the matching box 72 provided at the cathode unit 68. In this case, the installation number of matching boxes 72 provided in the electrode unit 31 may be two or more according to the status of use of the matching boxes 72.

In the above first embodiment, the configuration in which a total of two power feeding points 88 which are respectively provided on upper and lower lateral surfaces in the height direction, are disposed at the cathode intermediate member 76, has been described.

For this reason, for example, when a film having nonuniform quality is formed on the post-processed substrate W2 so as to correspond to the positions of the power feeding points 88 disposed at the cathode intermediate member 76, the quality of a film to be formed on the post-processed substrate W2 can be separately adjusted by shifting the phase of a voltage input to one power feeding point 88, and the phase of a voltage input to the other power feeding point 88.

Therefore, according to the above-described embodiment, even if the shower plate (cathode 75) is enlarged, the electrical potential of the whole shower plate (cathode 75) can be uniformly set by providing the cathode intermediate member 76 with two or more power feeding points 88, by adjusting the operating conditions of the matching box 72, and by adjusting the phases of voltages at a plurality of power feeding points 88.

Additionally, it is possible to adjust the phases of voltages applied to the respective power feeding points 88 and 88 while checking the quality of a film formed on the post-processed substrate W2.

Moreover, it is possible to arrange the anodes 67 on both sides of the cathode intermediate member 76 so as to face the cathode intermediate member, thereby simultaneously forming films on two substrates W in a space where space-saving has been realized.

### (Second Embodiment)

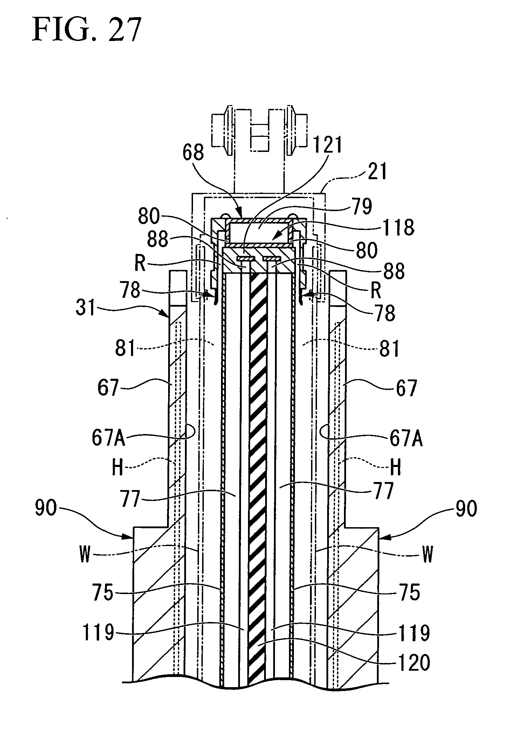

Next, a second embodiment of the present invention will be described referring back to FIG. 5 and on the basis of FIG. 27. In addition, the same members as the first embodiment will be designated by the same reference numerals and described (this is also the same in the following embodiments).

The fundamental configuration of the second embodiment is the same as that of the aforementioned first embodiment in that the thin-film solar cell manufacturing apparatus 10 includes the film forming chambers 11 capable of simultaneously film-forming bottom cells 104 (semiconductor layers) made of microcrystalline silicon on a plurality of substrates W; the loading-ejecting chambers 13 capable of simultaneously storing both pre-processed substrates W1 which are to be transported to the film forming chambers 11 and post-processed substrates W2 which have been transported from the film forming chambers 11; the substrate replacement chambers 15 where the pre-processed substrates W1 and the post-processed substrates W2 are attached to and detached from the carriers 21; the substrate replacement robot 17 for attaching and removing a substrate W to/from the carrier 21; and substrate storage holders 19 which hold substrates W to convey the substrates to a separate processing chamber; in that electrode units 31 are detachably provided in each film forming chamber 11; in that the heaters H are built in the anodes 67 of each electrode unit 31; and in that the drive mechanism 71 for driving the anodes 67, and the matching box 72 are attached to the side plate portion 63 of the electrode unit 31 (this is also the same in the following embodiments).

The cathode unit 118 of the second embodiment is arranged between the anodes 67 and 67 (anode units 90 and 90), and has a plate-shaped insulating member 120 disposed substantially at the center of the cathode unit 118 in its thickness direction (direction vertical to the plane of the shower plate 75). The insulating member 120 is installed between a pair of shower plates 75. In the cathode unit 118, a pair of RF applying members 119 is arranged substantially parallel to each other with the insulating member 120 interposed therebetween. The insulating member 120 is formed from, for example, alumina or quartz.

The pair of RF applying members 119 is members formed in the shape of a plate, respectively. The shower plates 75 are arranged so as to face the RF applying members 119, respectively.

Each shower plate 75 is arranged between the RF applying member 119 and the anode 67, and comes into contact with the surface of the RF applying member 119. Each shower plate 75 and the RF applying member 119 are connected together at the periphery of the RF applying member 119. A space portion 77 for introducing the film forming gas is formed between each shower plate 75 and each RF applying member 119.

In each RF applying member 119, a total of two power feeding points 88 to which the voltage of a high-frequency power source is applied via the matching box 72 are respectively disposed on upper and lower lateral surfaces (a top lateral surface and a bottom lateral surface or an upper portion and a lower portion) of the RF applying member 119 in the height direction. A wiring line 87 for electrically connecting the power feeding points 88 and the matching box 72 together is disposed between both 88 and 72.

The surroundings of the power feeding points 88, and the wiring line 87 are surrounded by an insulating member 121 made of, for example, alumina or quartz (refer to FIG. 5). Additionally, as shown in FIG. 27, the power feeding points 88 of each of the two RF applying members 119 is covered with the insulating member 121. The electrical potentials of the power feeding portion 88 are equal to each other at the top lateral surface and bottom lateral surface of the RF applying member 119 (equal electrical potential).

Accordingly, according to the above-described embodiment, in addition to the same effects as the above-described first embodiment, mutual interference between the two electrodes (cathodes) can be suppressed by this floating capacitance because the floating capacitance is provided by inserting a dielectric body (insulating member 120) between two cathodes.

### (Third Embodiment)

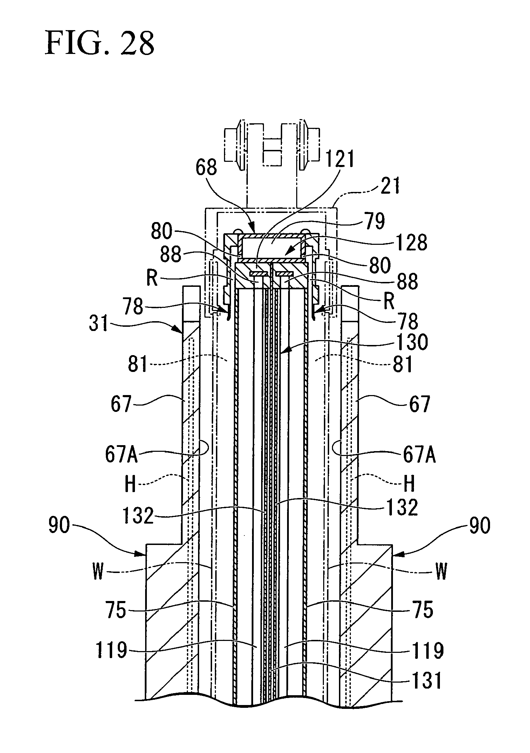

Next, a third embodiment of the present invention will be described with reference to FIG. 28.

The difference between a cathode unit 128 of the third embodiment and the cathode unit 118 of the aforementioned second embodiment is as follows. That is, in the cathode unit 118 of the aforementioned second embodiment, a pair of RF applying members 119 is arranged substantially parallel to each other with the insulating member 120 interposed therebetween. In contrast, in the cathode unit 128 of the third embodiment, a pair of cathode RF applying members 119 is arranged substantially parallel to each other with an inhibiting mechanism 130 which inhibits electric conduction interposed therebetween.

The inhibiting mechanism 130 is constituted of a plate-shaped grounding plate 131 and a pair of shield sections 132 and 132. The grounding plate 131 is arranged substantially at the center of the inhibiting mechanism 130 in its thickness direction (direction vertical to the plane of the shower plate 75). The shield sections 132 and 132 are respectively arranged on both sides of the grounding plate 131. The grounding plate 131 is interposed between the RF applying members 119 and 119. The RF applying members 119 and 119 and the shield sections 132 and 132 are separated to the right and left by the grounding plate 131. That is, the cathode unit 128 is electrically divided into both sides in its thickness direction by the grounding plate 131. Each of the pair of shield sections 132 and 132 is interposed between the grounding plate 131 and the RF applying member 119. By providing the shield section 132 or 132 installed between each of the two RF applying members 119 and 119 and the grounding plate with a certain floating capacitance, mutual interference between the two RF applying members 119 and 119 is prevented.

Methods for forming a floating capacitance between each of the two RF applying members 119 and 119, and the grounding plate may include (A) a method for sandwiching a dielectric body or (B) a method for forming a space of approximately 1 to 29 mm. Additionally, the method for forming a space may include (1) a method for superimposing electrically floating metal plates with a gap provided therebetween, or (2) a method for superimposing insulating plates with a gap provided therebetween.

Therefore, according to the above-described embodiment, in addition to the same effects as the aforementioned first embodiment, it is possible to apply voltages to be applied to the pair of RF applying members 119 without mutual interference therebetween because the inhibiting mechanism 130 which inhibits electric conduction is provided between the pair of RF applying members 119. For this reason, plasma can be generated in the two film formation spaces 81 without mutual interference between electric discharges.

Additionally, it is possible to individually set film forming conditions in the film formation spaces 81 and 81 formed between the shower plates (cathodes) 75 and substrates W, respectively, and film can be formed on two substrates W in the film forming conditions individually tuned to the substrates W. Hence, uniform and stable film forming is performed.

In addition, the technical scope of the invention is not limited to the above embodiments, but various modifications of the above-described embodiments may be made without departing from the scope of the invention. That is, the specific shapes and configurations as set mentioned in the embodiments are merely examples, and can be appropriately changed.

Additionally, the case where, a total of two power feeding points 88 to which the voltage of a high-frequency power source is applied via the matching box 72 are respectively disposed on upper and lower lateral surfaces of the cathode intermediate member 76 or the RF applying member 119 in the height direction has been described in the above-described embodiments.

However, the present invention is not limited thereto, and two or more power feeding points 88 according to the size of the cathode intermediate member 76 or RF applying member 119 and the conditions when a film is formed.

Although the configuration of the cathode intermediate member 76 and the RF applying member 119 in which two power feeding points 88 are disposed has been described in the above embodiment, the number of power feeding points 88 is not limited. Three or more power feeding points 88 may be provided. For example, four power feeding points 88 may be provided in four places of the cathode intermediate member 76 and RF applying member 119 so as to correspond to four sides of the substrate W. Additionally, four power feeding points 88 may be provided in four places of the cathode intermediate member 76 and RF applying member 119 so as to correspond to four corners of the substrate W. The number of power feeding points 88 and the positions where the power feeding points 88 are installed are appropriately adjusted according to the quality of a film to be formed in the post-processed substrate W2.

Moreover, the configuration in which the shower plate (cathode) 75 and the cathode intermediate member 76 are independent members, and these members are incorporated into the cathode unit 68 has been described in the above first embodiment. However, the present invention is not limited to this configuration, and a configuration in which the shower plate (cathode) 75 and the cathode intermediate member 76 are integrally formed may be adopted.

Moreover, the configuration in which the shower plate (cathode) 75 and the RF applying member 119 are independent members, and these members are incorporated into the cathode unit 68 has been described in the above-described second and third embodiments. However, the present invention is not limited to this configuration, and a configuration in which the shower plate (cathode) 75 and the RF applying member 119 are integrally formed may be adopted.

### Industrial Applicability

As described above in detail, the present invention is useful for a thin-film solar cell manufacturing apparatus which can form a uniform film on a film formation face of a substrate, even if a high-frequency electrode is enlarged or the conditions when a film is formed have changed.

## Claims

1. A thin-film solar cell manufacturing apparatus, comprising:
a film formation space in which a substrate is disposed so that a film formation face of the substrate is substantially parallel to a direction of gravitational force, and in which a desired film is formed on the film formation face by a CVD method;
a cathode unit including cathodes to which a voltage is applied, and two or more power feeding points, the cathodes being disposed at both sides of the cathode unit; and
an anode distantly disposed so as to face the cathodes that are disposed at both sides of the cathode unit.

2. A thin-film solar cell manufacturing apparatus, comprising:
a film formation space in which a substrate is disposed so that a film formation face of the substrate is substantially parallel to a direction of gravitational force, and in which a desired film is formed on the film formation face by a CVD method;
a cathode unit including cathodes to which a voltage is applied and an insulating member disposed between a pair of the cathodes, the cathodes having two or more power feeding points to which the same electrical potentials are applied, the cathodes being disposed at both sides of the cathode unit; and
an anode distantly disposed so as to face the cathodes that are disposed at both sides of the cathode unit.

3. A thin-film solar cell manufacturing apparatus, comprising:
a film formation space in which a substrate is disposed so that a film formation face of the substrate is substantially parallel to a direction of gravitational force, and in which a desired film is formed on the film formation face by a CVD method;
a cathode unit including cathodes to which a voltage is applied and a shield member disposed between a pair of the cathodes, the cathodes having two or more power feeding points to which electrical potentials different from each other are applied, the shield member having a ground potential, the cathodes being disposed at both sides of the cathode unit; and
an anode distantly disposed so as to face the cathodes that are disposed at both sides of the cathode unit.

4. A thin-film solar cell manufacturing apparatus, comprising:
a film formation space in which a substrate is disposed so that a film formation face of the substrate is substantially parallel to a direction of gravitational force, and in which a desired film is formed on the film formation face by a CVD method;
a cathode unit including cathodes to which a voltage is applied and a cathode intermediate member having two or more power feeding points disposed at a side face of the cathode intermediate member, the cathodes being disposed at both sides of the cathode intermediate member, and the cathodes being disposed at both sides of the cathode unit; and
an anode distantly facing the cathodes that are disposed at both sides of the cathode unit.
